# EUROPEAN PATENT APPLICATION

(11) **EP 4 192 036 A1**
(43) Date of publication of application: **07.06.2023**
(21) Application number: 21849937.4
(22) Date of filing: 01.07.2021
(51) Int. Cl.: H04R 19/04

(54) **PACKAGE, MICROPHONE DEVICE, AND ELECTRONIC APPARATUS**

(30) Priority: 31.07.2020 JP 2020130575
(71) Applicant: Kyocera Corporation, Kyoto-shi Kyoto 612-8501 (JP)
(72) Inventor: NAKAMOTO, Koutarou, Kyoto-shi, Kyoto 612-8501 (JP)
(74) Representative: Viering, Jentschura & Partner mbB Patent- und Rechtsanwälte
(86) International application number: PCT/JP2021/024891
(87) International publication number: WO 2022/024654

(57) **Abstract**

To realize a substrate shape capable of ensuring a required substrate thickness while improving acoustic characteristics. A package (400) on which a microphone element (3) is to be mounted, the package including a substrate (10) includes at least one recessed portion 13 in a region (R) corresponding to a mounting portion (18) of the microphone element (3) in the package (400). A bottom surface of the recessed portion (13) in the substrate (10) is a thin plate portion (11) that is thinner than thicknesses of other regions. The substrate (10) includes a plurality of through holes (12) in the thin plate portion (11).

## Description

### TECHNICAL FIELD

The present disclosure relates to a package for mounting a microphone element, a microphone device, and an electronic apparatus including the microphone device.

### BACKGROUND OF INVENTION

In recent years, a demand for a waterproof type in mobile devices such as smartphones has increased. One of devices implemented in the mobile device is a microphone device. The microphone device includes a microphone element that senses sound, and includes a through hole for allowing sound from the outside to pass through to the microphone element. Conventionally, a casing of the mobile device is provided with an opening portion that allows the through hole and the outside of the housing to communicate with each other, and in order to improve waterproof performance of the mobile device, means for protecting the opening portion with a waterproof sheet or the like from the inside of the casing is used.

Patent Document 1 discloses a technique in which a through hole serving as a sound hole formed in a substrate constituting a MEMS microphone semiconductor device is provided with an entry suppression shape for preventing entry of cutting water or cutting debris during processing in a manufacturing process.

Patent Document 2 discloses a waterproof cover body structure having a microchannel having a diameter from 0.1 mm to 0.6 mm and a length from 1 mm to 5 mm.

### CITATION LIST

### PATENT LITERATURE

Patent Document 1: JP 2010-268412 A
Patent document 2: JP 3201758 UM-B

### SUMMARY

A package according to an aspect of the present disclosure is a package on which a microphone element is to be mounted. The package includes a substrate including at least one recessed portion in a region corresponding to a mounting portion of the microphone element in the package. A bottom surface of the recessed portion in the substrate is a thin plate portion that is thinner than thicknesses of other regions, and the substrate has a plurality of through holes in the thin plate portion.

### BRIEF DESCRIPTION OF THE DRAWINGS

FIG. 1 is a cross-sectional view of a microphone device according to an embodiment.
FIG. 2 is a one point convergent view illustrating an upper surface of an example of a substrate.
FIG. 3 is a one point convergent view illustrating a lower surface of the example of the substrate.
FIG. 4 is an exemplary SEM photograph illustrating a cross-section of a through hole formed in a first layer.
FIG. 5 is a schematic cross-sectional view of a thin plate portion.
FIG. 6 is a schematic view illustrating an example of an arrangement of through holes when a bottom surface of a recessed portion is viewed in plan view.
FIG. 7 is a schematic view illustrating a comparative example with respect to FIG. 6.
FIG. 8 is a schematic cross-sectional view of the thin plate portion and a plan view of through holes when viewed from above the thin plate portion.
FIG. 9 is a schematic cross-sectional view of a thin plate portion.
FIG. 10 is a schematic plan view illustrating an example of an arrangement of through holes when a bottom surface of a recessed portion is viewed in plan view.
FIG. 11 is a cross-sectional view of a variation of the substrate.
FIG. 12 is a cross-sectional view of a variation of the substrate.
FIG. 13 is a cross-sectional view of a variation of the microphone device.
FIG. 14 is a cross-sectional view of a variation of the microphone device and a mounting substrate.
FIG. 15 is a cross-sectional view of a variation of the microphone device and the mounting substrate.
FIG. 16 is a cross-sectional view of a variation of the microphone device and the mounting substrate, illustrating a variation of a mounting manner.
FIG. 17 is a cross-sectional view of a variation of the microphone device and the mounting substrate.
FIG. 18 is a partial cross-sectional view of an electronic apparatus including the microphone device.
FIG. 19 is a partial cross-sectional view of the electronic apparatus, illustrating a mounting example of an upper sound hole type.
FIG. 20 is a cross-sectional view of a variation of the microphone device and a cross-sectional view of a variation of a wiring board.
FIG. 21 is a cross-sectional view of a variation of the microphone device.
FIG. 22 is a cross-sectional view of a variation of the microphone device, and the mounting substrate.
FIG. 23 is a view illustrating an outline of a device used in a waterproof test.
FIG. 24 is a cross-sectional view of a substrate of a microphone device used as a comparative example.
FIG. 25 is a graph showing resonant frequency simulation results for the microphone device of the present disclosure and the comparative example.
FIG. 26 is a cross-sectional view of a microphone device according to a second embodiment.
FIG. 27 is a cross-sectional view of a microphone device in a variation of the second embodiment.
FIG. 28 is a cross-sectional view of a microphone device and a mounting substrate according to a third embodiment.
FIG. 29 is a cross-sectional view of a microphone device and a mounting substrate according to a fourth embodiment.
FIG. 30 is a cross-sectional view of a microphone device and a mounting substrate according to a fifth embodiment.

### DESCRIPTION OF EMBODIMENTS

### First Embodiment

### Configuration of Microphone Device 200

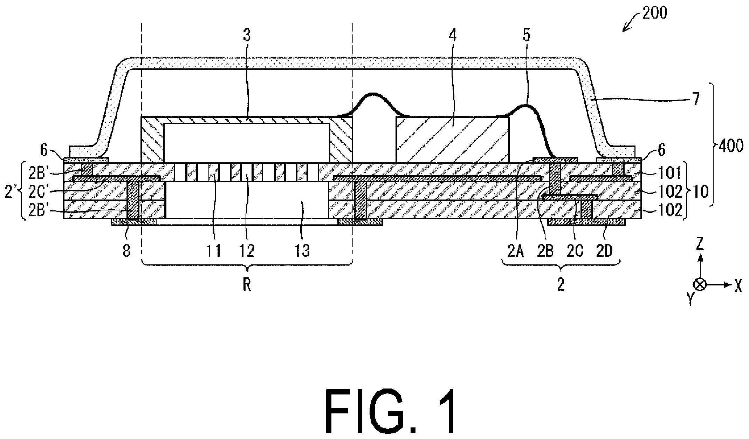

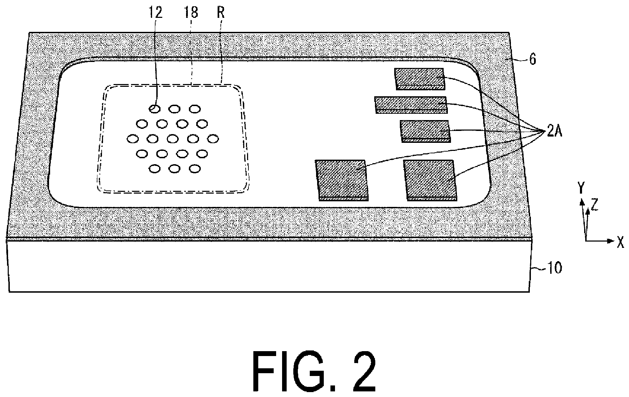

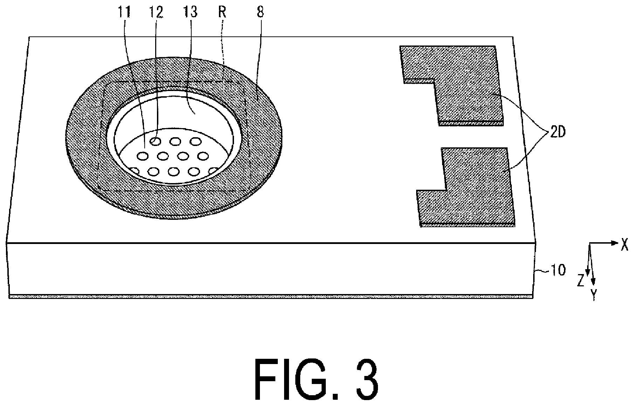

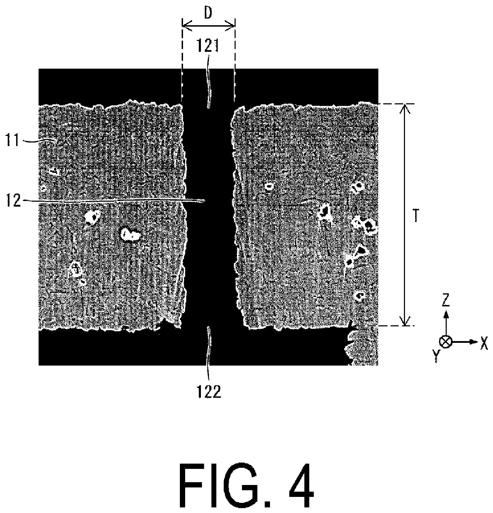

An embodiment of the present disclosure will be described in detail below with reference to accompanying drawings. Note that the terms "up/top" and "down/bottom" are used in the following description by way of convenience and may not be construed as limitations in the actual use of the package, the microphone device, and the electronic apparatus. FIG. 1 is a cross-sectional view of a microphone device 200 including a wiring board 10 (substrate) taken along a plane perpendicular to the wiring board 10 and parallel to an X axis direction. FIG. 2 is a one point convergent view illustrating an upper surface of an example of the wiring board 10. FIG. 3 is a one point convergent view illustrating a lower surface of the example of the wiring board 10. FIG. 4 is an example SEM photograph illustrating a cross-section of a through hole 12 formed in a thin plate portion 11.

Note that, in the present specification, in the wiring board 10, a surface on a side on which a microphone element is to be mounted is defined as an upper surface, and a positive direction in the Z axis direction in the drawings is referred to as an upward direction. The X axis direction is a long axis direction of the wiring board 10, and the Y axis is an axis that perpendicularly intersects the X axis and Z axis. In the drawings, when the cross-sectional view of the wiring board 10 is illustrated, the cross-sectional view is taken along the same or similar plane as/to that in FIG. 1 unless otherwise specified.

As illustrated in FIGs. 1 to 3, the microphone device 200 is a Micro Electro Mechanical System (MEMS) microphone device, and includes a package 400, a microphone element 3, a semiconductor element 4, and a sealing metal layer 8. The package 400 includes a lid 7 and a wiring board 10 as a substrate. In other words, the substrate according to the first embodiment is the wiring board 10 including a mounting portion 18 and a wiring conductor 2. Note that, in order to clearly illustrate the structure of the wiring board 10, FIG. 2 illustrates a state in which the microphone element 3, the semiconductor element 4, and the lid 7 are removed. The mounting portion 18 is provided on an upper surface of the wiring board 10 in a mounting position of the microphone element 3. A region overlapping the mounting portion 18 when the microphone device 200 is perspectively viewed in plan view from the Z axis direction is referred to as a region R.

The wiring board 10 is an example of a substrate including a recessed portion 13 in the region R. The wiring board 10 is a substrate on which the microphone element 3 is mounted. The wiring board 10 has functions of ensuring mechanical strength as the substrate for mounting the microphone element 3, ensuring an insulation property between the plurality of wiring conductors 2, and the like. The wiring board 10 has, for example, a quadrilateral shape such as a rectangular shape in plan view. In the wiring board 10, the thin plate portion 11 that is thinner than thicknesses of other regions is formed in the region R. In other words, the bottom surface of the recessed portion 13 in the wiring board 10 is the thin plate portion 11 that is thinner than the thicknesses of other regions. A plurality of the through holes 12 are formed in the thin plate portion 11.

The thin plate portion 11 forms the bottom surface of the recessed portion 13 formed in the wiring board 10. The through holes 12 and the recessed portion 13 act as sound holes that take sound from the outside. Not only the through holes 12 but also the recessed portion 13 that is larger than the through holes 12 is formed, and thus a space corresponding to the recessed portion 13 is formed between the lower surface and the upper surface of the wiring board 10. Thus, a spatial volume between the lower surface of the wiring board 10 that is the outer surface of the microphone device 200 and the microphone element 3 increases. Acoustic characteristics can be improved by the increase in the spatial volume. In the wiring board 10 of an embodiment, the recessed portion 13 is formed only on one side of the wiring board 10, and the microphone element 3 is mounted on a side opposite to a side where the recessed portion 13 is formed. In other words, an opening of the recessed portion 13 is located on a surface opposite to the mounting portion 18 in the wiring board 10. The shape of the recessed portion 13 when the bottom surface of the recessed portion 13 is viewed in plan view has a circular shape corresponding to a shape of a diaphragm of the microphone element 3. When the Z axis direction is defined as the thickness direction in the wiring board 10, a thickness T of the thin plate portion 11 is, for example, 0.02 mm or more and 0.20 mm or less. A diameter D of the through hole 12 is, for example, 0.010 mm or more and 0.050 mm or less. When the thickness T and the diameter D are within the ranges described above, the waterproof performance of the wiring board 10 can be improved. The shape of the recessed portion 13 when the bottom surface of the recessed portion 13 is viewed in plan view is, for example, a circular shape having a diameter of 0.1 mm or more and 1.0 mm or less.

As illustrated in FIG. 4, in one example, the through hole 12 is substantially perpendicular to the thin plate portion 11 and has a linear tube shape in which diameters of an upper surface opening portion 121 and a lower surface opening portion 122 of the through hole 12 are approximately equal to each other. Note that in the example illustrated in FIG. 4, the thickness T of the thin plate portion 11 is approximately 100 µm, and the diameter D of the through hole 12 is approximately 26 µm.

The wiring board 10 may form the recessed portion 13 by layering, for example, a first layer 101 (first insulation layer) including the thin plate portion 11 and at least one second layer 102 (second insulation layer) including an opening portion at a position corresponding to the thin plate portion 11. Each of the first layer 101 and the second layer 102 is an insulation layer composed of an insulation material including a ceramic material such as an aluminum oxide-based sintered body, a glass ceramic sintered body, a mullite-based sintered body, or an aluminum nitride-based sintered body.

In a case where the wiring board 10 is a laminate body including a plurality of the insulation layers, the first layer 101 including the thin plate portion 11 including the through holes 12 and the second layer 102 including the opening portion to be the recessed portion 13 as another insulation layer may be laminated. The opening portion of the second layer 102 is located in a region where the through holes 12 in the first layer 101 are disposed, in other words, in a position corresponding to the thin plate portion 11. The wiring board 10 in the example illustrated in FIG. 1 is the laminate body including one first layer 101 and two second layers 102 located below the first layer 101.

Each of the thicknesses of the first layer 101 and the second layer 102 is, for example, 0.02 mm or more and 0.20 mm or less. The example illustrated in FIG. 1 includes three insulation layers, but the number of layers of the insulation layer is not limited to three. The wiring board 10 is not limited to the layered form, and may be integrally formed. The thickness of the wiring board 10 other than the thin plate portion 11 is preferably at least two times or more the thickness T of the thin plate portion 11 in order to ensure strength as the substrate.

In a case where the wiring board 10 is the laminate body (ceramic body) composed of, for example, the aluminum oxide-based sintered body, the wiring board 10 can be fabricated in the following manner. Specifically, first, ceramic green sheet (green sheet) to be the first layer 101 and the second layer 102 is produced. Raw material powder of aluminum oxide, silicon oxide, or the like is formed into a sheet shape together with an appropriate organic binder and an organic solvent to produce a plurality of ceramic green sheets having a square sheet shape. The through holes 12 are formed, for example, in the ceramic green sheet corresponding to the first layer 101 by punching using a die or the like. A hole diameter at the time of punching is such a size that the hole diameter after firing is 0. 010 mm or more and 0. 050 mm or less. The opening portion corresponding to the recessed portion 13 is formed, for example, in the ceramic green sheet corresponding to the second layer 102 using a die or the like. These ceramic green sheets are laminated to produce a laminate body. Then, the wiring board 10 can be fabricated by subjecting this laminate body to firing at a temperature of 1300 to 1600°C.

Since the ceramic green sheet shrinks by an amount from approximately 10% to 20% by firing, the hole formed in the green sheet can have a hole diameter larger by an amount from approximately 10% to 20% than the diameter of the through hole 12 after firing. Since the ceramic green sheet before firing is a soft material, fine hole processing as described above is easy. Thus, in a case where the wiring board 10 is formed by the ceramic laminate body, forming of the fine through hole having, for example, a diameter of 0.1 mm or less is easy, which is generally considered to be difficult in a case of a metal substrate or an organic substrate.

The thinner the ceramic green sheet is, the easier it is to form the fine through hole 12. By using a thin green sheet as the ceramic green sheet constituting the first layer 101, the fine through hole 12 can be easily formed. The ceramic green sheet constituting the second layer 102 can have a thickness and the number of layers depending on strength required for the wiring board 10. In other words, one or more insulation layers having the same configuration as the second layer 102 may overlap the second layer 102. The number of layers of the insulation layers constituting the wiring board 10 can be the number of layers required for developing the wiring conductor 2. The wiring board 10 is the laminate body in which the insulation layer (first layer 101) including the fine through holes 12 and another insulation layer (second layer 102) are layered, and thus the wiring board 10 includes the fine through holes and the required substrate thickness is easily ensured.

The wiring conductor 2 is provided on the surface and in an inner portion of the wiring board 10. For example, in the example illustrated in FIGs. 1 to 3, the wiring board 10 includes a connection pad 2A, a terminal electrode 2D, a through hole conductor 2B, and an internal wiring layer 2C as the wiring conductor 2. The connection pad 2A for connecting to the semiconductor element 4 and a bonding metal layer 6 are provided on the upper surface of the wiring board 10. The terminal electrode 2D for connecting to an external electrical circuit is provided on the lower surface of the wiring board 10. The connection pad 2A and the terminal electrode 2D are electrically connected to each other by the through hole conductor 2B and the internal wiring layer 2C provided in the inner portion of the wiring board 10. The through hole conductor 2B passes through the insulation layers, and the internal wiring layer 2C is disposed between the insulation layers. The terminal electrode 2D may be provided from the lower surface to the side surface, or on the side surface, instead of on the lower surface of the wiring board 10. The sealing metal layer 8 surrounding the opening of the recessed portion 13 is provided on the lower surface of the wiring board 10.

The wiring conductor 2, the bonding metal layer 6, and the sealing metal layer 8 mainly include, for example, metal such as tungsten, molybdenum, manganese, copper, silver, palladium, gold, platinum, nickel, and cobalt, or an alloy containing these metals as a conductor material. The wiring conductor 2, the bonding metal layer 6, and the sealing metal layer 8 are formed on the surface of the wiring board 10 as a metal layer such as a metallization layer or plating layer of the conductor material. The metal layer may be a single layer, or a plurality of layers. The wiring conductor 2 is formed in the inner portion of the wiring board 10 by metallization of the conductor material.

In a case where the connection pad 2A, the internal wiring layer 2C, the terminal electrode 2D, the bonding metal layer 6, and the sealing metal layer 8 of the wiring conductor 2 are, for example, a metallization layer of tungsten, these components can be formed as follows. Specifically, these components can be formed by a method in which a metal paste produced by mixing a powder of tungsten with an organic solvent and an organic binder is printed at a predetermined position of the ceramic green sheet to be the wiring board 10 by a method such as a screen printing method and then fired. A plating layer of nickel, gold, and the like may be further deposited on an exposed surface of metallization layer to be serving as the connection pad 2A, the terminal electrode 2D, the bonding metal layer 6, and the sealing metal layer 8 among the above-described components using electrolytic plating, electroless plating, or the like. The through hole conductor 2B may be formed by providing a through hole in a predetermined position of the ceramic green sheet prior to printing of the metal paste described above and filling the through hole with a metal paste that is the same as or similar to that described above and firing the metal paste.

The microphone element 3 is a MEMS microphone semiconductor element (MEMS transducer) having a diaphragm structure or a beam structure, for example, a sensor device including a vibrating electrode, and is fixed to the mounting portion 18 (see FIG. 2) on the wiring board 10. For example, the microphone element 3 is fixed such that the lower surface of the microphone element 3 is bonded to the mounting portion 18 of the wiring board 10 by a bonding material (not illustrated) such as solder or a resin-based adhesive so that the inner portion of the element is sealed in the mounting portion 18. An electrode (not illustrated) disposed on the upper surface of the microphone element 3, and the wiring board 10 or the semiconductor element 4 are electrically connected to each other by a connecting member 5.

In the microphone device 200, the terminal electrode 2D provided on the lower surface of the wiring board 10 of the wiring conductor 2 and the external electrical circuit are electrically connected to each other, and thus the microphone element 3 mounted on the wiring board 10 and the external electrical circuit are electrically connected to each other. In other words, the microphone element 3 and the external electrical circuit are electrically connected to each other via the connecting member 5 such as a bonding wire and the wiring conductor 2. The external electrical circuit is, for example, an electrical circuit included in a mounting substrate (circuit board) mounted on an electronic apparatus such as a smartphone.

The microphone element 3 includes, for example, a diaphragm and a back plate. The diaphragm and the back plate act like a parallel flat plate type capacitor, and when the diaphragm vibrates due to sound pressure, a gap length between the diaphragm and the back plate changes and an electrostatic capacitance changes. The microphone element 3 transmits this change as an electrical signal to the semiconductor element 4.

The semiconductor element 4 is, for example, an integrated circuit such as an Application Specific Integrated Circuit (ASIC) and the like. The semiconductor element 4 has, for example, a function of amplifying the electrical signal received from the microphone element 3. The semiconductor element 4 is, for example, electrically connected to the microphone element 3 and the wiring board 10 by the connecting member 5. In addition to the semiconductor element 4, a passive component (not illustrated) such as a capacitor may be mounted on the wiring board 10. The passive component is, for example, connected to the connection pad 2A by soldering.

In the example illustrated in FIG. 1, the microphone element 3 is sealed and protected by the lid 7 on the upper surface side of the wiring board 10. In the example illustrated in FIG. 1, the microphone device 200 includes the lid 7 having a box shape (cap shape) collectively covering the connection pad 2A, the microphone element 3, and the connecting member 5, which are on the upper surface of the wiring board 10.

The lid 7 is made of a material such as metal, resin, and ceramics, and is bonded to the wiring board 10. The lid 7 may be bonded via a sealing bonding material. Examples of the sealing bonding material include, for example a resin adhesive, glass, and a brazing material including a solder. When the lid 7 and the wiring board 10 are bonded to each other using the brazing material, the bonding metal layer 6 may be provided on the upper surface of the wiring board 10 so as to surround the region R on the upper surface of the wiring board 10 and the connection pad 2A disposed on the outer side of the region R. In a case where the lid 7 is metal, the lid 7 may be bonded to the bonding metal layer 6 on the wiring board 10 by a welding method such as seam welding, laser welding, or the like. In the case of bonding using the brazing material or the like, an overall heating by reflow heating is performed, whereas in a case of bonding by the seam welding or the laser welding, local heating of only the bonding portion can be performed. Thus, influence of heat on the microphone element 3 and the semiconductor element 4 can be reduced. The bonding metal layer 6 may be formed of, for example a metal film such as a plating film, a metallization layer, or the like. In a case where the lid 7 is formed of a material having low wettability (bonding property) of the brazing material such as resin or ceramics, the bonding metal layer may be formed also on the lid 7.

In a case where the lid 7 is made of an electrical conductive material such as a metal, the lid 7 can function as a shield member against noise entering from outside. As illustrated in FIG. 1, the bonding metal layer 6 and the sealing metal layer 8 may be connected to each other by a wiring conductor 2' (a through hole conductor 2B'and an internal wiring layer 2C') for grounding. Since the sealing metal layer 8 is connected to the ground potential of the external circuit, the lid 7 is connected to the ground potential of the external circuit via the wiring conductor 2 and the sealing metal layer 8. According to this configuration, the lid 7 can connect to the ground potential via the bonding metal layer 6, and a shield property of the microphone device 200 can be further enhanced. Thus, acoustic noise is reduced, and the reliability of operation is improved.

### Example of Through Holes 12

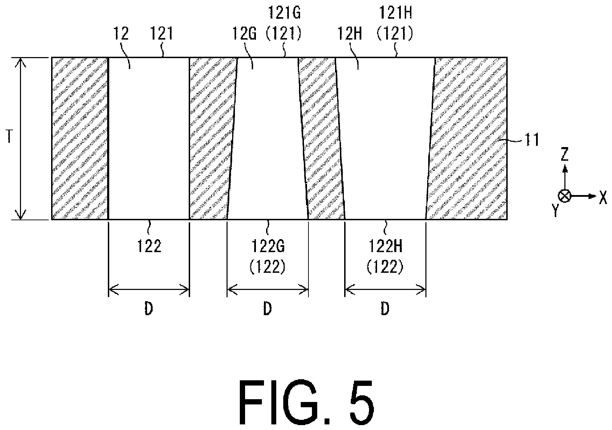

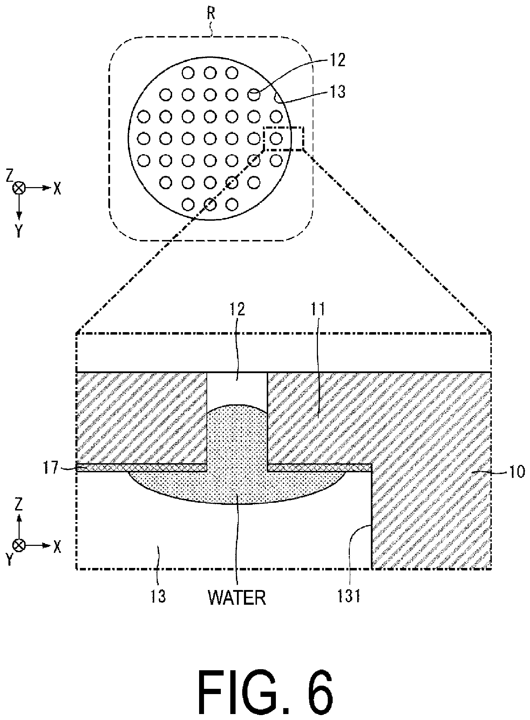

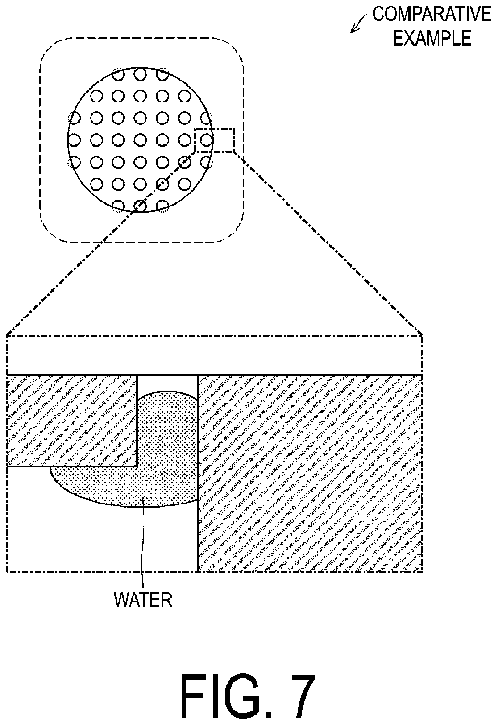

Another aspect of the through holes 12 formed in the thin plate portion 11 will be described in more detail with reference to FIGs. 5 to 9. First, aspects of the through holes 12 of the thin plate portion 11 preferred for reducing entry of water will be described with reference to FIGs. 5 to 7. FIG. 5 is a schematic cross-sectional view of the thin plate portion 11, illustrating another aspect of the through holes 12. FIG. 6 illustrates an example of an arrangement of the through holes 12 when the bottom surface of the recessed portion 13 is viewed in plan view. FIG. 7 illustrates a comparative example with respect to FIG. 6.

For example, waterproof property of a level equivalent to IPX7 is required for the electronic apparatus equipped with the microphone device. In the entry suppression shape described in Patent Document 1, a diameter of the through hole is large. Thus, it is difficult to realize the waterproof property of the level equivalent to IPX7. In a case where a porous film is provided in the through holes in order to improve the waterproof performance, a problem arises in that microphone characteristics are degraded. In other words, a problem arises in that sound (sonic wave vibration) reaching the microphone element through the porous film may be deteriorated as compared with sound reaching the microphone element without passing through the porous film. There is also a problem in that by using the porous film, which is a separate member from the wiring board 10, costs of the package and the microphone device 200 increases, and the manufacturing process of the wiring board 10 is complicated.

The microchannel structure described in Patent Document 2 has the waterproof property of the IPX7 level, but the microchannel structure cannot be applied in its original dimensions to the substrate for a small and thin substrate for the microphone element.

Under such a circumstance, the present inventors have intensively studied a substrate having a structure capable of suppressing degradation in the microphone characteristics (acoustic characteristics) and having the waterproof property while satisfying conditions of dimensions (substrate thickness and the like) required for a microphone element substrate, and have realized the substrate of the present disclosure.

As illustrated in FIG. 5, the through holes 12 may have a configuration in which the size of an upper surface opening portion 121 and the size of a lower surface opening portion 122 are different from each other. In FIG. 5, a through hole 12G illustrates an example in which an upper surface opening portion 121G is smaller than a lower surface opening portion 122G. A through hole 12H illustrates an example in which an upper surface opening portion 121H is larger than a lower surface opening portion 122H.

In FIG. 5, it is assumed that the side of the lower surface opening portion 122 faces the outside and is a water entering side. It is important to reduce a diameter of the lower surface opening portion 122 to obtain the desired waterproof performance. Thus, the diameter of the lower surface opening portion 122 (opening portion on a side in contact with water) of the through hole 12 is preferably 0.050 mm or less. A diameter of the upper surface opening portion 121 is preferably 0.075 mm or less.

In a case where the diameter of the lower surface opening portion 122 is larger than the diameter of the upper surface opening portion 121 as in the through hole 12G, it is conceivable that it is relatively easy for moisture to enter the through hole 12G from the lower surface. On the other hand, in a case where the diameter of the upper surface opening portion 121 is larger than the diameter of the lower surface opening portion 122 as in the through hole 12H, it is conceivable that water entering into the inner portion of the through hole 12G from the lower surface is likely to rise to the upper surface. It is also conceivable that the larger the difference in diameter between the upper surface opening portion 121 and the lower surface opening portion 122, the higher the possibility described above. From the above, the through hole 12 preferably has an angle of 90° ± 15° or less between the lower surface of the thin plate portion 11 and the inner wall of the through hole 12, and further preferably has a linear tubular shape in which the diameters of the upper surface opening portion 121 and the lower surface opening portion 122 are substantially equal to each other.

The thickness T (in other words, a distance between the lower surface opening portion 122 and the upper surface opening portion 121 of the through hole 12) is preferably greater than two times the diameter D of the lower surface opening portion 122.

As illustrated in FIG. 6, the through holes 12 are preferably formed separated from an outer edge 131 of the recessed portion 13 when the bottom surface of the recessed portion 13 is viewed in plan view. According to this configuration, a portion where water extends can be ensured around the through hole 12 on the lower surface of the thin plate portion 11, and thus it is difficult for water to enter the through hole 12 due to surface tension. In the comparative example illustrated in FIG. 7, the through holes are not separated from the outer edge of the recessed portion, and thus water is likely to enter the inner portions of the through holes along the outer edge of the recessed portion. By forming the through holes 12 away from the outer edge 131 of the recessed portion 13, the possibility of water entry can be further reduced.

In order to improve the waterproof performance, a coating layer 17 having a water-repellent function may be provided on the lower surface of the thin plate portion 11. The coating layer 17 may be formed not only on the thin plate portion 11, but also on the entire lower surface of the wiring board 10. The coating layer 17 having the water-repellent function can be formed by, for example, immersing the wiring board 10 into a processing liquid containing fluorine and drying the processing liquid. By applying pressure or reducing pressure during immersion in the processing liquid, the processing liquid may also be allowed to enter the through hole 12, and the coating layer may be formed on the inner wall of each of the through holes 12. When the coating layer 17 is provided, water cannot easily enter the through holes 12, and thus the hole diameter of each of the through holes 12 can be increased as compared with a case where the coating layer 17 is not provided. This can improve the acoustic characteristics.

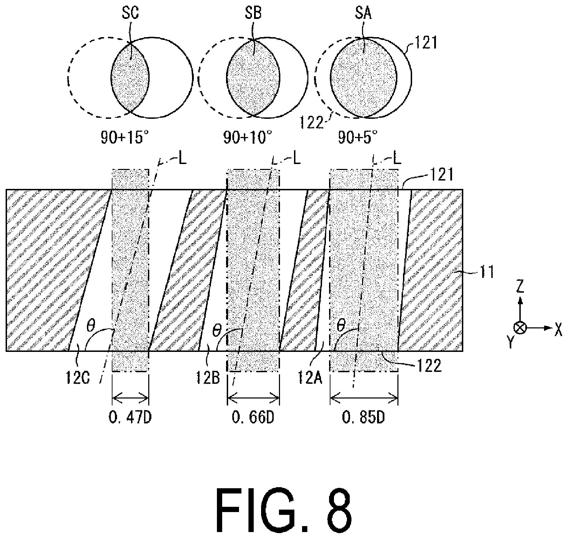

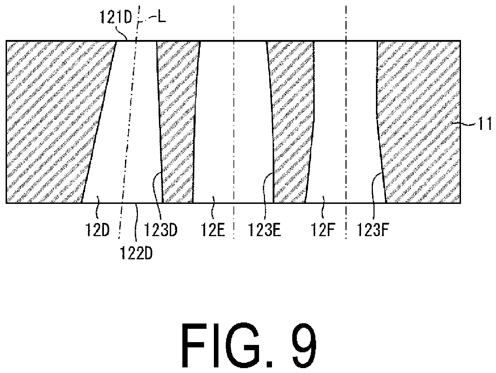

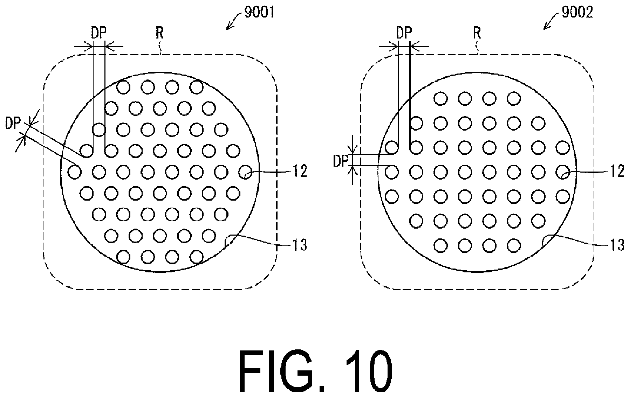

An aspect of the through holes 12 preferred for the microphone device 200 to have good acoustic characteristics will be described with reference to FIGs. 5, and 8 to 10. FIG. 8 is a schematic cross-sectional view of the thin plate portion 11 and a plan view of the through holes 12 when viewed from above the thin plate portion 11, illustrating another aspect of the through holes 12. FIG. 9 is a schematic cross-sectional view of the thin plate portion 11, illustrating another aspect of the through holes 12. FIG. 10 is a schematic plan view illustrating examples of an arrangement of through holes 12 when the bottom surface of the recessed portion 13 is viewed in plan view.

The through holes 12 may have a configuration in which the through holes 12 are inclined with respect to the upper surface or the lower surface of the thin plate portion 11, as in a through hole 12A, a through hole 12B, and a through hole 12C illustrated in FIG. 8. In FIG. 8, the through hole 12A is an example in which a virtual center line L connecting the center of the upper surface opening portion 121 and the center of the lower surface opening portion 122 is inclined by 90° + 5° (angle θ = 95°) with respect to the upper surface or the lower surface of the thin plate portion 11. When the diameter of the lower surface opening portion 122 of the through hole 12A is D, a length in the X axis direction of an overlapping region SA overlapping the upper surface opening portion 121 and the lower surface opening portion 122 in plan view is approximately 0.85D. The through hole 12B is an example in which the virtual center line L is inclined by 90° + 10° (angle θ = 100°) with respect to the upper surface or the lower surface of the thin plate portion 11. When the diameter of the lower surface opening portion 122 of the through hole 12B is D, a length in the X axis direction of an overlapping region SB is approximately 0.66D. The through hole 12C is an example in which the virtual center line L is inclined by 90° + 15° (angle θ = 105°) with respect to a substrate surface. When the diameter of the lower surface opening portion 122 of the through hole 12C is D, a length in the X axis direction of an overlapping region SC is approximately 0.47D.

The through holes 12 also have a function as sound holes. Examples of main acoustic characteristics of the microphone device 200 include sensitivity and frequency characteristics. In order to obtain a good sensitivity, it is preferable that a surface area of an overlapping region S (SA, SB, and SC in FIG. 8) in which the upper surface opening portion 121 and the lower surface opening portion 122 of the through hole overlap each other is large when the thin plate portion 11 is viewed in plan view. In order to obtain the desired sensitivity, the virtual center line L is preferably 90° ±10° or less with respect to the upper surface or the lower surface of the thin plate portion 11, and more preferably 90° ± 5° or less.

The through holes 12 may be in a form such as a through hole 12D, a through hole 12E, and a through hole 12F illustrated in FIG. 9. The through hole 12D in FIG. 9, is an example in which the hole diameters of an upper surface opening portion 121D and a lower surface opening portion 122D are different from each other, and the virtual center line L is inclined with respect to the upper surface or the lower surface of the thin plate portion 11. The through hole 12E is an example in which an inner wall surface 123E of the through hole 12E is a curved surface. The through hole 12F is an example in which an inner wall surface 123F of the through hole 12F is a bending surface. As in the through hole 12E and the through hole 12F, the inner wall surface 123 of the through hole may have gentle curve or gentle bend. As in the through hole 12G and the through hole 12H illustrated in FIG. 5, the size of an upper surface opening portion 121 and the size of a lower surface opening portion 122 may be configured to be different from each other.

On the other hand, in a case where the inclination of the inner wall is large in the through hole 12G illustrated in FIG. 5 and the through hole 12D illustrated in FIG. 9, the acoustic characteristics is likely to be degraded. In a case where degrees of the curve of the inner wall surface 123E of the through hole 12E illustrated in FIG. 9 and the bend of the inner wall surface 123F of the through hole 12F illustrated in FIG. 9 are large, the acoustic characteristics is likely to be degraded.

From the above, in consideration of the waterproof property and the acoustic characteristics, the through hole 12 preferably has a straight cylindrical shape extending in a direction substantially perpendicular to the lower surface of the thin plate portion 11 with the hole diameter of the upper surface opening portion 121 and the hole diameter of the lower surface opening portion 122 of the through hole 12 being substantially the same size.

The arrangement of the through holes 12 in the thin plate portion 11 is not particularly limited. Reference numeral 9001 in FIG. 10 illustrates an example in which the through holes 12 have a staggered arrangement when the bottom surface of the recessed portion 13 is viewed in plan view. Reference numeral 9002 in FIG. 10 illustrates an example in which the through holes have a lattice arrangement.

The distance between the through holes 12 has the same inter-hole distance DP in both of the staggered arrangement of reference numeral 9001 and the lattice arrangement of reference numeral 9002. On the other hand, when comparing the staggered arrangement of reference numeral 9001 and the lattice arrangement of reference numeral 9002, the number of through holes 12 at the bottom surface of the recessed portion 13 is larger in the staggered arrangement of reference numeral 9001. In other words, the staggered arrangement can dispose the through holes 12 having the same diameter in a region having the same surface area as compared with the lattice arrangement having the same inter-hole distance DP. In order to obtain good acoustic characteristics, a ratio of the sum of the total surface area of the hole portions of the through holes 12 to the surface area of the bottom surface of the recessed portion 13 is preferably higher. In other words, the number of the through holes 12 at the bottom surface of the recessed portion 13 is preferably larger. Note that, since the distance DP between the through holes 12 is the same, even when the number of through holes 12 increases by adopting the staggered arrangement, influence on the strength of the thin plate portion 11 is considered to be low. From the above, in consideration of the acoustic characteristics, the arrangement of the through holes 12 is preferably the staggered arrangement. By arranging the plurality of through holes 12 in the staggered arrangement, the acoustic characteristics of the microphone device 200 can be improved.

### Gist of Effect of First Embodiment

The package 400 according to an aspect of the present disclosure is the package 400 on which the microphone element 3 is to be mounted. The package 400 includes the wiring board 10 (substrate) including at least one recessed portion 13 in the region R corresponding to the mounting portion 18 of the microphone element 3 in the package 400, the bottom surface of the recessed portion 13 in the wiring board 10 is the thin plate portion 11 that is thinner than the thicknesses of other regions, and the wiring board 10 includes the plurality of through holes 12 in the thin plate portion 11.

According to the configuration described above, the thin plate portion 11 is formed only in the region R, and thus the substrate thickness required for ensuring the strength as the substrate can be ensured in other regions in the wiring board 10. The through holes 12 that act as the sound holes are formed in the thin plate portion 11, and thus good acoustic characteristics can be provided. In other words, the microphone device having the good acoustic characteristics can be realized. The recessed portion 13 is formed in the wiring board 10, and thus a ratio of the space between the opening in contact with the outside and the microphone element 3 increases, and good acoustic characteristics can be obtained.

In the package 400 according to an aspect of the present disclosure, the opening of the recessed portion is located on a surface opposite to the mounting portion 18 in the wiring board 10.

According to the configuration described above, the recessed portion 13 is formed on the lower surface of the wiring board 10, and thus the possibility of damage to the thin plate portion 11 due to contact with an external article can be reduced. The recessed portion 13 acts as an air reservoir, and thus the possibility that water from the outside reaches the thin plate portion 11 can be reduced. Furthermore, no recessed portion 13 is present on the upper surface of the wiring board 10, and thus the mounting portion 18 is likely to be flat, and the possibility that the microphone element 3 is inclined when mounted is reduced.

The wiring board 10 according to an aspect of the present disclosure includes the plurality of through holes 12 in the thin plate portion 11 of the bottom surface of one recessed portion 13.

The region R of the wiring board 10 includes one recessed portion 13 including the plurality of through holes 12, and thus the ratio of the space between the opening in contact with the outside and the microphone element 3 further increases, and further good acoustic characteristics can be obtained.

The plurality of through holes 12 according to one aspect of the present disclosure do not allow water to permeate when the wiring board 10 is submerged in water at a depth of 1 m for 30 minutes.

According to the configuration described above, the package 400 and the microphone device 200 having the waterproof performance of the IPX 7 level can be realized. According to the configuration described above, the package 400 and the microphone device 200 also having excellent dust resistance can be realized.

The plurality of through holes 12 according to one aspect of the present disclosure are formed separated from the outer edge of the recessed portion 13 when the bottom surface of the recessed portion 13 is viewed in plan view. According to the configuration described above, the waterproof performance can be improved.

The plurality of through holes 12 according to one aspect of the present disclosure have the staggered arrangement when the bottom surface of the recessed portion 13 is viewed in plan view. According to the configuration described above, the acoustic characteristics (microphone characteristics) can be improved.

The wiring board 10 according to an aspect of the present disclosure includes the coating layer 17 having the water-repellent function on a surface of the wiring board 10 opposite to a side on which the microphone element 3 is mounted. According to the configuration described above, the waterproof performance can be further improved.

The wiring board 10 according to an aspect of the present disclosure is the laminate body including the plurality of insulation layers, and includes the first layer 101 (first insulation layer) including the thin plate portion 11, and the second layer 102 (second insulation layer) in contact with the first layer 101 and including the opening portion at a position corresponding to the thin plate portion 11.

By laminating the plurality of layers to form the wiring board 10, a desired wiring conductor 2 can be formed in the inner portion of the wiring board 10. The through holes 12 are formed only in the first insulation layer 101, and thus the fine through holes 12 can be easily formed. By forming the wiring board 10 as the laminate body, the wiring board 10 has the fine through holes 12, and the required substrate thickness is easily ensured.

The insulation layers (first layer 101 and second layer 102) according to one aspect of the disclosure are ceramic insulation layers. According to the configuration described above, the ceramic itself has waterproof property, and thus the wiring board 10 composed of the ceramic insulation layer can reduce the possibility of deterioration such as corrosion, swelling, and deformation due to absorption of moisture.

### First Variation

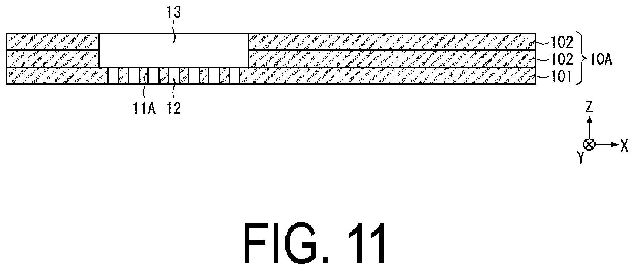

FIG. 11 is a cross-sectional view of a wiring board 10A, which is a variation of the wiring board 10. In FIG. 11, the wiring conductor and the like are omitted, and only insulation layers are illustrated. In FIG. 11, the microphone element 3 is mounted on an upper surface of the wiring board 10A. In other words, the recessed portion 13 of the wiring board 10A is formed only on one side of the wiring board 10A, and a mounting position of the microphone element 3 is on a side where the recessed portion 13 is formed. In other words, the opening of the recessed portion 13 is located on a surface opposite to the mounting portion (not illustrated) in the wiring board 10A.

According to the configuration described above, the possibility that the water entering through the opening portion formed in the mounting substrate (see the description of a fourth variation described later) reaches the microphone element 3 is reduced by the first layer 101. Even when water enters through the through hole 12, a space is formed by the recessed portion 13 between the microphone element 3 and the first layer 101, and thus the water is less likely to reach the microphone element 3.

Even in a case where a bonding material bonding the microphone element 3 and the second layer 102 is expanded in the manufacturing process of the microphone device 200, the bonding material can be limited in a very small part of the inner wall of the recessed portion 13 or the thin plate portion 11A. Thus, the possibility that the through holes 12 are blocked by the bonding material can be reduced.

The recessed portion 13 is formed on a side on which the microphone element 3 of the wiring board 10A is mounted, and thus an advantage is that the alignment of the microphone elements 3 is facilitated with reference to the recessed portion 13 when the microphone element 3 is mounted.

### Second Variation

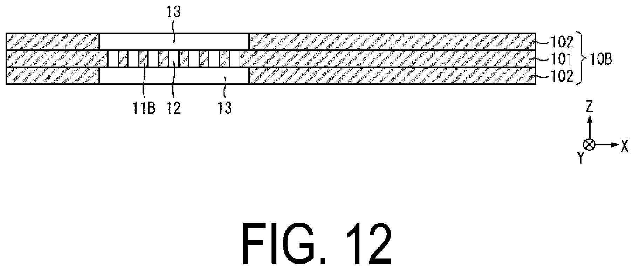

FIG. 12 is a cross-sectional view of a wiring board 10B, which is a variation of the wiring board 10. In FIG. 12, the wiring conductor and the like are omitted, and only insulation layers are illustrated. In FIG. 12, the microphone element 3 is mounted on an upper surface of the wiring board 10B. In other words, the opening of the recessed portion 13 is located on both surfaces of the wiring board 10B with a thin plate portion 11B interposed therebetween.

According to the configuration described above, the recessed portion 13 is formed on an upper surface of the wiring board 10B, and thus the same or similar effect as/to that of the first variation can be obtained.

The recessed portion 13 is formed on the lower surface of the wiring board 10B, and thus the possibility of damage to the thin plate portion 11B due to contact with an external article can be reduced. The recessed portion 13 on the lower surface side acts as the air reservoir, and thus the possibility that water from the outside reaches the thin plate portion 11 can be reduced.

### Third Variation

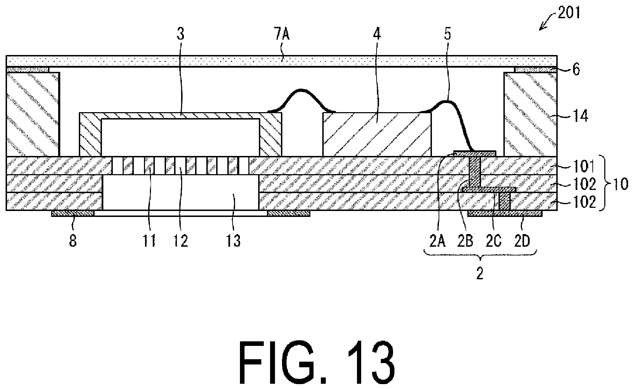

FIG. 13 is a cross-sectional view of a microphone device 201, which is a variation of the microphone device 200. The microphone device 201 includes a frame-shaped portion 14. The frame-shaped portion 14 forms a housing recessed portion that houses the microphone element 3, the connection pad 2A, and the connecting member 5. The frame-shaped portion 14 may be made of the same insulation material as the insulation layers (the first layer 101 and the second layer 102). The frame-shaped portion 14 may be integrally formed with the wiring board 10. The microphone device 201 includes a lid 7A having a plate shape that blocks an opening of the housing recessed portion.

Other configurations of the microphone device 201 are the same as and/or similar to the configurations of the microphone device 200 of the first embodiment illustrated in FIG. 1. The frame-shaped portion 14 is integrally formed with the insulation layers (the first layer 101 and the second layer 102), and thus the wiring board 10 includes a cavity that houses the microphone element 3 on the upper surface. As a result, by integrally forming the frame-shaped portion 14, the thickness of the wiring board 10 is increased, and thus the strength is improved. Further, the bonding portion of the lid 7A is away from the mounting position of the microphone element 3 and the semiconductor element 4, and thus influence of heat when the lid 7A is welded is reduced. The lid 7A has a flat plate shape, and thus manufacturing is easy and cost can be suppressed.

### Fourth Variation

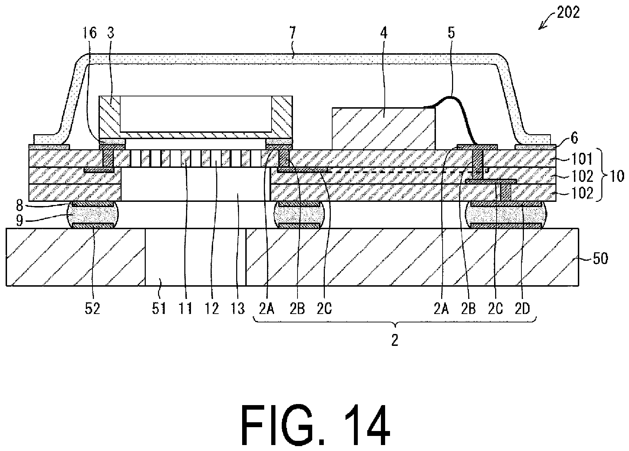

FIG. 14 is a cross-sectional view of a microphone device 202 and a mounting substrate 50 as a variation. In the microphone device 202, the microphone element 3 and the wiring board 10 are flip-chip connected to each other. In other words, the microphone element 3 is connected to the connection pad 2A via a terminal 16. In this case, the microphone element 3 is connected to the semiconductor element 4 via the wiring conductor 2 in the wiring board 10. FIG. 14 illustrates an example in which the microphone device 202 has the lid 7 of a box type, but the configuration for protecting the microphone element 3, the semiconductor element 4, the connecting member 5, and the connection pad 2A is not limited to this example.

The microphone device 202 is mounted on the mounting substrate 50 such that a side including the recessed portion 13 of the wiring board 10 faces the mounting substrate 50. The microphone device 202 is mounted on the mounting substrate 50 by connecting the terminal electrode 2D and the sealing metal layer 8 of the microphone device 202 to a wiring 52 of the mounting substrate 50 via an electrically conductive bonding material 9. As a result, the microphone device 202 is electrically connected to the mounting substrate 50.

The sealing metal layer 8 is provided so as to surround the opening of the recessed portion 13. The sealing metal layer 8 is bonded to the mounting substrate 50 via the electrically conductive bonding material 9 such as solder, and thus the possibility that water entering through an opening portion 51 of the mounting substrate 50 spreads through between the microphone device 202 and the mounting substrate 50 can be reduced. The electrically conductive bonding material 9 functions as a sealing material.

Note that, for example, in a case where, instead of the solder, a resin adhesive (including electrically conductive adhesive) is used as the electrically conductive bonding material 9, or in a case where a sealing material that does not adhere such as an O-ring is inserted between the microphone device 202 and the mounting substrate 50, the sealing metal layer 8 need not be formed. The same or similar mounting method applies to other embodiments.

### Fifth Variation

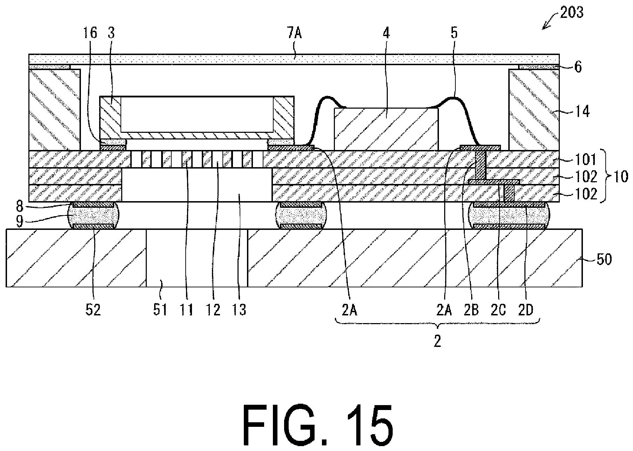

FIG. 15 is a cross-sectional view of a microphone device 203 and the mounting substrate 50 as a variation. In the microphone device 203, the microphone element 3 and the wiring board 10 are flip-chip connected to each other. In other words, the microphone element 3 is connected to the connection pad 2A via a terminal 16. In the microphone device 203, the microphone element 3 is connected to the semiconductor element 4 via the connection pad 2A and the connecting member 5. FIG. 15 illustrates an example in which the microphone device 203 includes the lid 7A of a flat plate type, but the configuration for protecting the microphone element 3, the semiconductor element 4, the connecting member 5, and the terminal electrode 2D is not limited to this example.

The microphone device 203 is mounted on the mounting substrate 50 such that a side including the recessed portion 13 of the wiring board 10 faces the mounting substrate 50.

### Six Variation

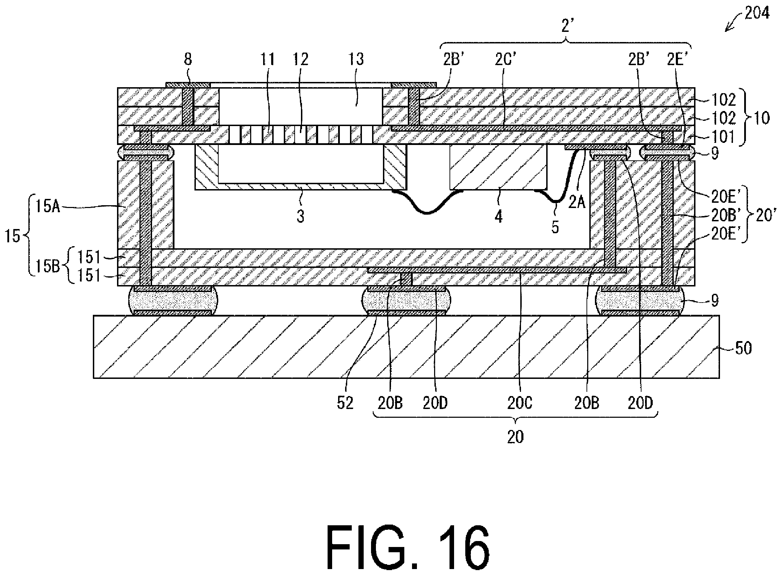

FIG. 16 is a cross-sectional view of a microphone device 204 and the mounting substrate 50, illustrating a variation of a mounting manner in which a lower surface of the microphone device 204 is mounted toward a side opposite to a side facing the mounting substrate 50. This mounting embodiment is configured to include the recessed portion 13 and the through holes 12 as the sound holes opposite to the mounting substrate 50 in the microphone device 204, and is also referred to as an upper sound hole type.

FIG. 16 is an example in which the wiring board 10 of the example in FIG. 1 is mounted upside down. The microphone device 204 includes a relay substrate 15 (connecting substrate) for electrically connecting the wiring board 10 and the mounting substrate 50 to each other. The wiring board 10 includes a wiring conductor 2' for grounding connected to the sealing metal layer 8. The wiring conductor 2' includes a through hole conductor 2B', an internal wiring layer 2C', and electrical conductor layer 2E'. The internal wiring layer 2C' covers a large part of a region other than the recessed portion 13 in plan view of the wiring board 1. In other words, the internal wiring layer 2C' overlaps elements such as the microphone element 3 housed in the microphone device 204, the wiring conductor, and the like in the region other than the recessed portion 13 in plan view. The electrical conductor layer 2E' is provided in a frame shape in an outer peripheral portion of an upper surface (surface facing the relay substrate 15) of the wiring board 10, and is connected to an electrical conductor layer 20E' of the relay substrate 15 described later via the electrically conductive bonding material 9.

The relay substrate 15 includes a frame-shaped portion 15A and a flat plate portion 15B that blocks an opening of the frame-shaped portion 15A. The flat plate portion 15B may include a plurality of insulation layers 151 in order to increase the degree of freedom of wiring. In FIG. 16, an example is illustrated, in which the flat plate portion 15B includes two insulation layers 151, but the number of the insulation layers 151 is not limited to two. The relay substrate 15 constitutes an insulator having a cap shape including a recessed portion by the frame-shaped portion 15A and the flat plate portion 15B. The relay substrate 15 also has a function as a lid, and seals the microphone element 3 and the like mounted on the wiring board 10 by bonding the wiring board 10 and the relay substrate 15 to each other.

The relay substrate 15 includes a wiring conductor 20 as a wiring for a signal. The wiring conductor 20 includes a terminal electrode 20D, a through hole conductor 20B, and an internal wiring layer 20C. The terminal electrode 20D connected to the connection pad 2A of the wiring board 10 is provided on an upper surface (surface facing the wiring board 10) of the frame-shaped portion 15A. The terminal electrode 20D for connecting to an external electrical circuit is provided on a lower surface (a surface facing the mounting substrate 50) of the flat plate portion 15B. The two terminal electrodes 20D are electrically connected to each other by the through hole conductor 20B and the internal wiring layer 20C provided in the inner portion of the relay substrate 15. The wiring conductor 2 (connection pad 2A) of the wiring board 10 and the wiring 52 of the mounting substrate 50 are electrically connected to each other by the wiring conductor 20.

The relay substrate 15 further includes a wiring conductor 20' as a wiring for grounding. The wiring conductor 20' includes electrical conductor layers 20E' and a through hole conductor 20B'. The electrical conductor layer 20E' provided on the upper surface of the frame-shaped portion 15A can be provided in a frame shape along the outer periphery of the frame-shaped portion 15A so as to be located outside the terminal electrode 20D and separated from the terminal electrode 20D. The electrical conductor layer 20E' provided on the lower surface side of the frame-shaped portion 15A can be provided in a frame shape along the outer periphery of the flat plate portion 15B, and is connected to the ground potential of the external circuit via the electrically conductive bonding material 9. The through hole conductor 20B' is disposed to pass through the frame-shaped portion 15A and the flat plate portion 15B. A plurality of the through hole conductors 20B' are disposed in an outer peripheral portion of the relay substrate 15 (frame-shaped portion 15A) in plan view, and the recessed portion of the relay substrate 15 is surrounded by the plurality of through hole conductors 20B'. The through hole conductor 20B' electrically connects the electrical conductor layer 20E' on the upper surface and the electrical conductor layer 20E' on the lower surface of the relay substrate 15 to each other.

According to this configuration, the microphone element 3 and the like are surrounded by the wiring conductor 2' of the wiring board 10 and the wiring conductor 20'of the relay substrate 15, and thus shield property of the microphone device 204 can be further enhanced.

In the example in FIG. 16, the electrically conductive bonding material 9 bonding the wiring board 10 and the relay substrate 15 functions as an electrical connection material and functions as a sealing material. In the example in FIG. 16, the electrically conductive bonding material 9 may be configured by disposing an anisotropic conductive resin or the like in the frame shape along the outer periphery of the relay substrate 15. As a result, sealing can be performed without short-circuiting between the plurality of terminal electrodes 20D (between the terminal electrodes 2D). Each of the plurality of terminal electrodes 2D and a respective one of the wiring conductors 20 (terminal electrodes 20D) of the relay substrate 15 may be connected to each other by the electrically conductive bonding material 9, and the sealing material may be disposed outside the electrically conductive bonding material 9. In a case where the sealing material is the brazing material, solder, or the like, a frame-shaped sealing metal layer for sealing material can be provided.

### Seventh Variation

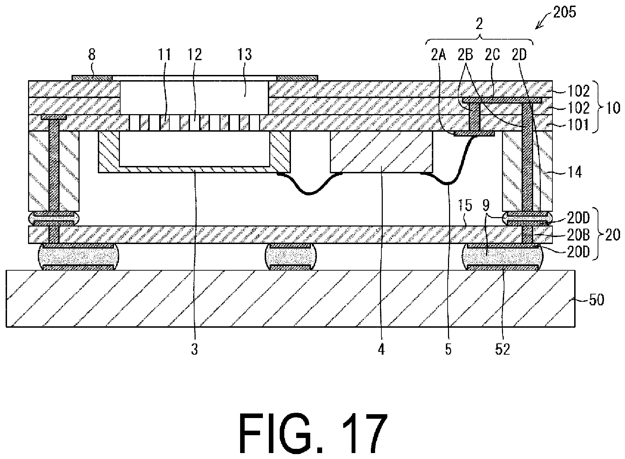

FIG. 17 is an example in which the wiring board 10 of the example in FIG. 15 is mounted upside down. A microphone device 205 includes the relay substrate 15 for electrical connection with the mounting substrate 50, and the wiring conductor 2 of the wiring board 10 is drawn to an upper surface of the frame-shaped portion 14. In the example in FIG. 17, the relay substrate 15 has a flat plate shape. As the same as or similar to the example in FIG. 16, the relay substrate 15 includes the wiring conductor 20. The relay substrate 15 also serves as a lid, and seals the microphone element 3 and the like mounted on the wiring board 10. In other words, it can be said that a wiring is provided in the lid having the flat plate shape.

### Mounting Example on Electronic Apparatus

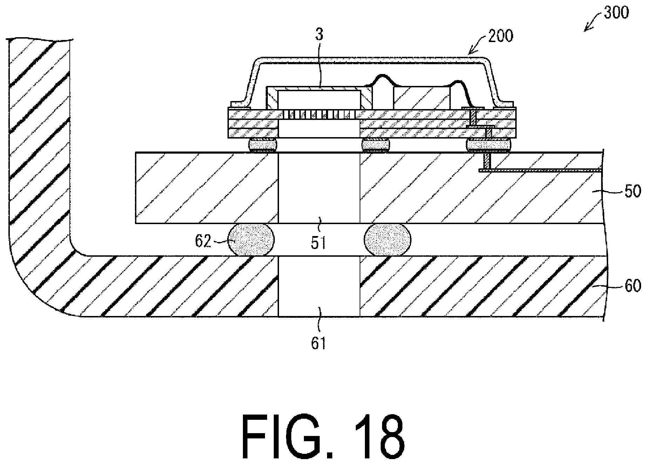

FIG. 18 is a partial cross-sectional view of an electronic apparatus 300 including the microphone device 200. The electronic apparatus 300 is not particularly limited, but is, for example, a communication information terminal such as a smartphone, a game console, and an earphone. An opening portion 61 serving as a sound hole is formed in a casing 60 of the electronic apparatus 300. In the electronic apparatus 300, the microphone element 3, the opening portion 51 of the mounting substrate 50, and the opening portion 61 of the casing 60 are aligned and disposed so as to communicate with each other. A sealing material 62 having a ring shape is disposed between the casing 60 and the mounting substrate 50 along outer edges of the opening portion 61 and the opening portion 51. The sealing material 62 may be a solder material or a gasket. Examples of the material of the sealing material 62 include a rubber-based resin, a metal such as solder. The sealing material 62 may be interposed between the casing 60 and the mounting substrate 50, or the casing 60 and the mounting substrate 50 may be adhered (bonded) by the sealing material 62.

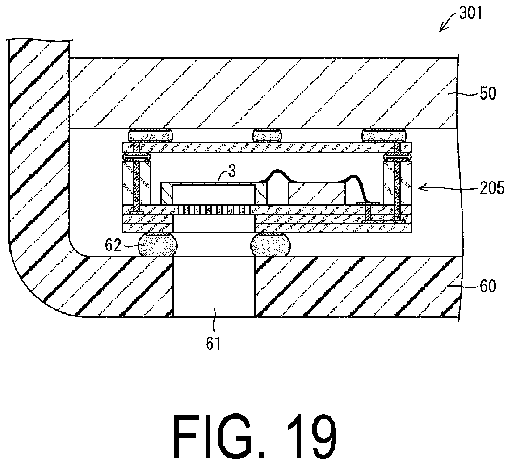

FIG. 19 is a partial cross-sectional view of the electronic apparatus 301, illustrating a mounting example of the upper sound hole type. In a case of the upper sound hole type, the microphone device 205 is disposed between the mounting substrate 50 and the casing 60. In the electronic apparatus 301, the microphone element 3 and the opening portion 61 of the casing 60 are aligned and disposed so as to communicate with each other. The sealing material 62 having the ring shape is disposed between the casing 60 and the microphone device 205 along outer edges of the opening portion 61.

According to the configuration described above, the electronic apparatus 301 having excellent waterproof property and dust resistance can be realized while improving the acoustic characteristics.

### Eighth Variation

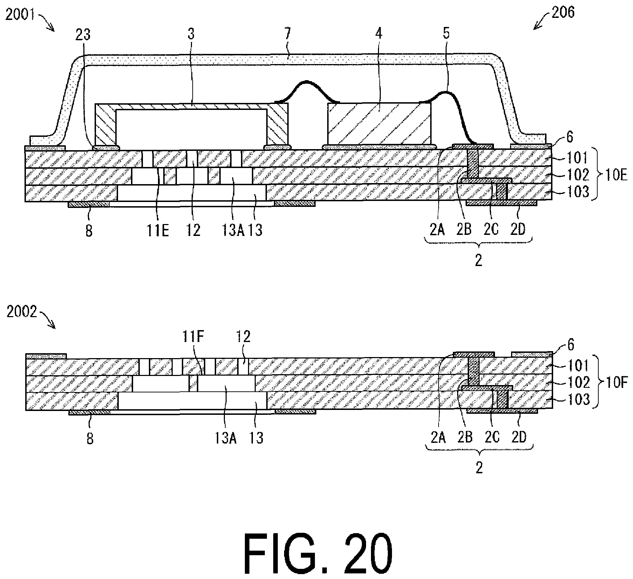

FIG. 20 is a cross-sectional view of a microphone device 206 and a cross-sectional view of a wiring board 10F for illustrating a variation of the wiring board 10. Reference numeral 2001 is a cross-sectional view of the microphone device 206 including a wiring board 10E, and reference numeral 2002 is a cross-sectional view of the wiring board 10F.

As illustrated by reference numeral 2001 in FIG. 20, the recessed portion 13 of the wiring board 10E of the microphone device 206 has a two-stage shape including a plurality of second recessed portions 13A on the bottom surface, and a bottom surface of each of the plurality of second recessed portions 13A is the thin plate portion 11E. One through hole 12 is formed in the thin plate portion 11E corresponding to the bottom portion of each of the plurality of second recessed portions 13A. The wiring board 10E forms the recessed portion 13 by layering the first layer 101, the second layer 102, and a third layer 103 in this order. The first layer 101 forms the thin plate portion 11E. The second layer 102 is in contact with the first layer 101, and includes a plurality of opening portions (second recessed portions 13A) formed at a position corresponding to the thin plate portion 11E. Each of the plurality of opening portions is one size larger than a respective one of the plurality of through holes 12 of the first layer 101, and is provided to correspond to the respective one of the plurality of through holes 12. The third layer 103 is in contact with the second layer 102 and includes an opening portion having a larger diameter than the opening portion of the second layer 102, and having a size such that the through holes 12 and the opening portions of the second layer 102 are located inner side of the opening portion of the third layer 103 in plan view. The wiring board 10E includes the recessed portion 13 formed by the opening portion formed in the third layer 103 and the opening portions formed in the second layer 102.

The recessed portion 13 of the wiring board 10F also has a two-stage shape including a plurality of second recessed portions 13A on the bottom surface, and a bottom surface of each of the plurality of second recessed portions 13A is the thin plate portion 11F. A plurality of through holes 12 are formed in the thin plate portion 11F corresponding to the bottom portion of each of the plurality of second recessed portions 13A. The second layer 102 of the wiring board 10F includes opening portions, each opening portion being larger than a respective one of the plurality of through holes 12 of the first layer 101 and containing the plurality of through holes 12 inside the opening portion. The third layer 103 includes an opening portion having the size such that the plurality of through holes 12 and the plurality of opening portions of the second layer 102 are located inner side of the opening portion in plan view.

By configuring the wiring board 10E and the wiring board 10F as described above, a space corresponding to the recessed portion 13 is formed between the lower surface and the upper surface of the wiring board 10, and the acoustic characteristics of the microphone device 206 are improved. As compared with a case where the recessed portion 13 does not have the two-stage shape, the strength of the substrate can be improved, and thus the wiring boards 10E and 10F can be made thinner.

### Ninth Variation

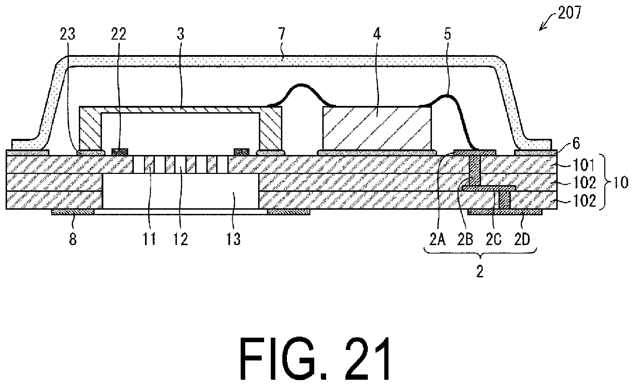

FIG. 21 is a cross-sectional view of a microphone device 207 as a variation of the microphone device 200. The microphone device 207 is different from the microphone device 200 illustrated in FIG. 1 in that a protruding portion 22 is provided on the wiring board 10, as illustrated in FIG. 21. A shape of the protruding portion 22 in plan view is an annular shape surrounding the plurality of through holes 12. The protruding portion 22 is provided between the through holes 12 and the bonding portion between the microphone element 3 and the wiring board 10. Note that in a case where the opening of the recessed portion 13 is located on a surface on a mounting portion side in the wiring board 10, the protruding portion 22 is provided between the opening of the recessed portion 13 and the bonding portion between the microphone element 3 and the wiring board 10.

The microphone element 3 is fixed to the wiring board 10 by, for example, a bonding material 23. By providing the protruding portion 22 on the wiring board 10, the possibility that the bonding material 23 blocks the through holes 12 can be reduced. The protruding portion 22 may be formed on the wiring board 10 by metallization or printing with alumina material.

### Tenth Variation

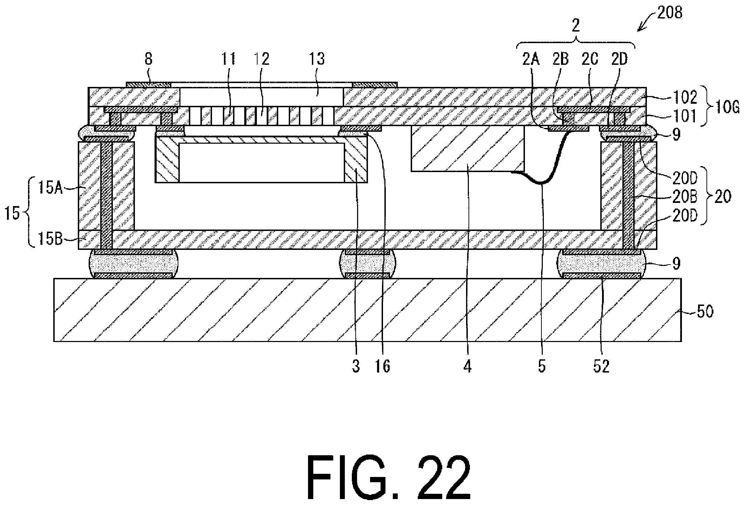

FIG. 22 is a cross-sectional view of a microphone device 208 and the mounting substrate 50 as a variation. The microphone device 208 is an example in which the microphone element 3 of the example in FIG. 16 is changed to a flip-chip connection. As in the microphone device 208 illustrated in FIG. 22, the microphone element 3 may be flip-chip connected in a microphone device 211 of the upper sound hole type.

### Other Variations

The wiring board 10 may be made of, for example, an insulation resin material such as epoxy, epoxy-glass composite material, and the like. More specifically, a resin substrate (printed circuit board) such as FR4 and FR5 may be used.

### Demonstration Test 1: Waterproof Test

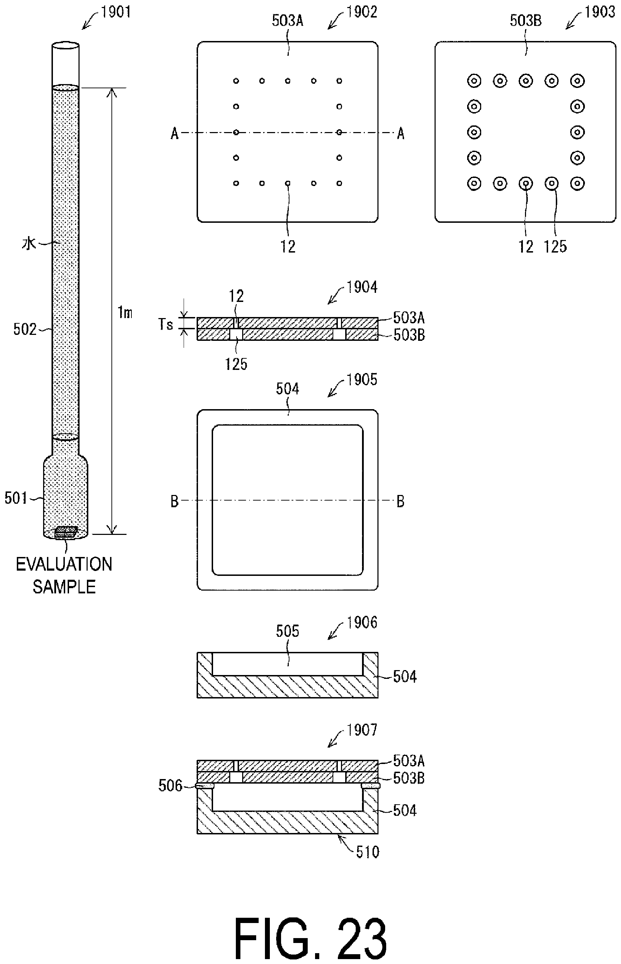

Hereinafter, a waterproof test will be described with reference to FIG. 23, in which the diameter D of the through hole 12 and a thicknesses Ts of the through hole 12 are variously changed to examine whether water entry occurs when water pressure at the water depth 1 m is applied for 30 minutes. FIG. 23 is a view illustrating an outline of a device used in the waterproof test. When the water entry does not occur while an evaluation sample 510 is submerged for 30 minutes in a state in which a distance from an upper surface of the evaluation sample 510 to water surface is 1 m, it can be determined that the waterproof performance is at the IPX7 level.

FIG. 23 is a schematic view illustrating the device used in the waterproof test. Reference numeral 1901 in FIG. 23 illustrates an overall view of the device used in the waterproof test. The evaluation sample 510 was installed at a bottom portion of the device in which a sample bottle 501 and a circular tube 502 are connected to each other, and the waterproof test for 30 minutes was conducted in a state where the inside of a container is filled with water so that the height from an upper surface of the evaluation sample 510 to the water surface is 1m. The evaluation sample 510 is configured such that a sample substrate (an upper layer 503A and lower layer 503B) and a cavity substrate 504 are bonded to each other by a resin adhesive. Reference numeral 1902 in FIG. 23 illustrates a top view of the sample substrate of the evaluation sample 510, and reference numeral 1903 illustrates a bottom view of the sample substrate of the evaluation sample 510. Reference numeral 1904 illustrates a cross-sectional view taken along line A-A of reference numeral 1902. The sample substrate includes two layers, and through holes 12 are formed in the upper layer 503A, which is in contact with water. The thickness of the upper layer 503A is, in other words, the thickness Ts of the through hole. Each of hole portions 125 having a larger hole diameter than a respective one of the through holes 12 is formed in the lower layer 503B at a position corresponding to the respective one of the through holes 12. The hole portions 125 correspond to the recessed portion 13 of the board 10.

Reference 1905 is a top view of the cavity substrate 504, and reference numeral 1906 illustrates a cross-sectional view taken along line B-B of reference numeral 1905. Reference numeral 1907 illustrates a cross-sectional view of the evaluation sample 510.

Each of the upper layer 503A, the lower layer 503B, and the cavity substrate 504 of the evaluation sample 510 was produced using an alumina-based sintered body without coating. Surface roughness Ra of the upper layer 503A, the lower layer 503B, and the cavity substrate 504 was less than 2.0 µm.

After a test time of 30 minutes, the sample substrate was removed from the cavity substrate 504, and then the presence of the water entry in the cavity 505 was confirmed using a 10-power microscope. Each example was evaluated using 20 evaluation samples. The through holes having the hole diameter of 0.051 mm and the through hole thickness of 0.1 mm were tested using 10 the same and/or similar evaluation samples as a comparative example.

Table 1 is a correspondence table of the hole diameters and the through hole thicknesses of the tested evaluation samples for the examples.

**Table 1**

| | | THROUGH HOLE THICKNESS (Ts) [mm] | | | | |
|---|---|---|---|---|---|---|
| | | 0.076 | 0.089 | 0.100 | 0.114 | 0.127 |
| HOLE DIAMETER (D) [mm] | ϕ0.026 | Good | Good | Good | | |
| | ϕ0.034 | | Good | Good | Good | |
| | ϕ0.042 | | | Good | Good | Good |

Table 2 is a table showing results of the waterproof test of the evaluation samples and comparative example shown in Table 1. Each of examples 1 to 9 in Table 2 corresponds to any of good marks in Table 1.

**Table 2**

| | EXAMPLE | | | | | | | | | COMPARATIVE EXAMPLE |
|---|---|---|---|---|---|---|---|---|---|---|
| | 1 | 2 | 3 | 4 | 5 | 6 | 7 | 8 | 9 | |
| HOLE DIAMETER [mm] | 0.026 | | | 0.034 | | | 0.042 | | | 0.051 |
| THROUGH HOLE THICKNESS (Ts) [mm] | 0.076 | 0.089 | 0.100 | 0.089 | 0.100 | 0.114 | 0.100 | 0.114 | 0.127 | 0.100 |
| NUMBER OF WATER ENTRY (N = 20) | 0/20 | 0/20 | 0/20 | 0/20 | 0/20 | 0/20 | 0/20 | 0/20 | 0/20 | 2/10 |

As shown in Table 2, the water entry from the through holes 12 was not confirmed in any of examples 1 to 9. In other words, it was demonstrated that all of examples 1 to 9 meet the waterproof property of IPX 7 level. For the comparative example, the water entry was confirmed in two evaluation samples out of 10 evaluation samples.

### Demonstration Test 2: Microphone Characteristics Test

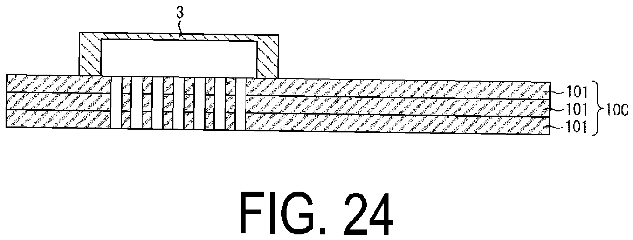

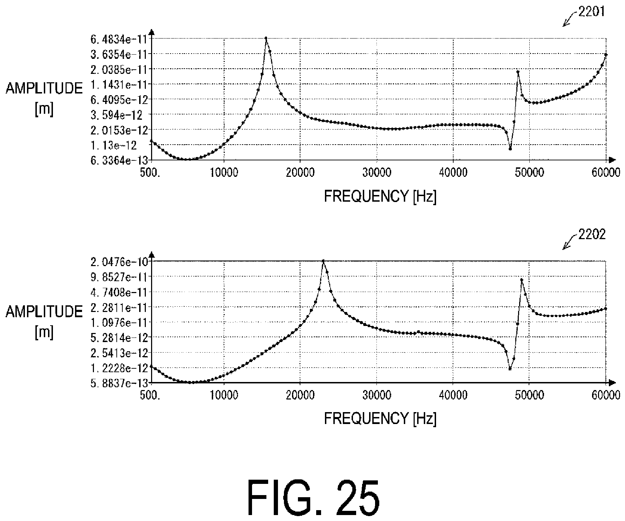

In the following, a microphone characteristics test will be described with reference to FIGs. 24 and 25 in which differences in the microphone characteristics between the microphone device 200 and the comparative example were investigated by examining a resonant frequency. FIG. 24 is a cross-sectional view of a wiring board 10C of a microphone device used as the comparative example. As illustrated in FIG. 24, the wiring board 10C is a substrate that does not include the thin plate portion. FIG. 25 is a graph showing resonant frequency simulation results for the microphone device 200 of the present disclosure and the comparative example. In FIG. 25, reference numeral 2201 illustrates a result obtained from the comparative example, and reference numeral 2202 indicates a result obtained using the microphone device 200 of the present disclosure.

As shown in FIG. 25, the resonant frequency of the comparative example was approximately 15500 Hz, and the resonant frequency of the microphone device 200 of the present disclosure was approximately 23000 Hz.

As the distance to the resonant frequency on the horizontal axis is longer, the frequency range that can be used as the microphone device is wider, and thus it can be determined that the microphone characteristics are good. In other words, it has been demonstrated that the microphone device 200 of the present disclosure includes the thin plate portion, and thus the microphone characteristics are good as compared with the comparative example that does not include the thin plate portion.

### Second Embodiment

Another embodiment of the present disclosure will be described with reference to accompanying drawings. Note that, for convenience of description, a member having the same function as that of a member described in the embodiments described above is denoted by the same reference sign, and description thereof will be omitted.

In the first embodiment, as the example of the package and the microphone device of the present disclosure, the package 400 and the microphone device 200 (201, 202,•••, 208) are described. The package 400 includes the wiring board 10 including the recessed portion 13, and the bottom surface of the recessed portion 13 is the thin plate portion 11. The microphone device 200 includes the package 400 and the microphone element 3. In contrast, in the present embodiment, as the example of the package and the microphone device of the present disclosure, a package 500A and a microphone device 210 will be described. The package 500A includes the recessed portion 13 and includes a perforated lid (substrate) 7B in which the bottom surface of the recessed portion 13 is a thin plate portion 11C. The microphone device 210 includes the package 500A and the microphone element 3.

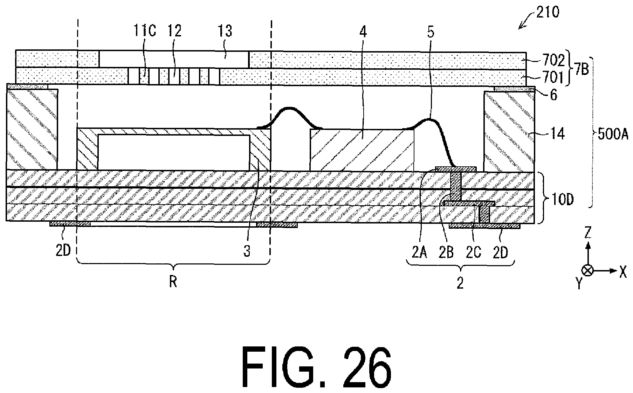

FIG. 26 is a cross-sectional view of the microphone device 210 according to the present embodiment. As illustrated in FIG. 26, the microphone device 210 includes the package 500A, the microphone element 3, the semiconductor element 4, and the connecting member 5.

The package 500A in the present embodiment includes a wiring board 10D, the frame-shaped portion 14, and the perforated lid 7B. The wiring board 10D differs from the wiring board 10 in the first embodiment describe above in that the wiring board 10D does not include the recessed portion 13 and the thin plate portion 11. The wiring board 10D includes three insulation layers, and is provided with the wiring conductor 2 through the inner portion of the wiring board 10D so as to energize from the upper surface to the bottom surface, but is not limited thereto. The wiring board 10D may be provided with the mounting portion 18 (see FIG. 2) on which the microphone element 3 is mounted, and other structures are not particularly limited. Known wiring boards may be used as the wiring board 10D.

The package 500A includes the housing recessed portion formed by the wiring board 10D and the frame-shaped portion 14 provided on the upper surface of the wiring board 10D, and members such as the microphone element 3, the semiconductor element 4, and the connecting member 5 can be housed in the housing recessed portion. The perforated lid 7B is disposed in the package 500A so as to cover the housing recessed portion. The perforated lid 7B and the frame-shaped portion 14 may be bonded to each other by, for example, the brazing material via a bonding metal layer 6 provided on the perforated lid 7B. Note that means for bonding the perforated lid 7B and the frame-shaped portion 14 to each other is not particularly limited.

A region overlapping the mounting portion 18 when the microphone device 210 is viewed in plan view from the Z axis direction is referred to as a region R, and the perforated lid 7B in the present embodiment includes the recessed portion 13 in the region R corresponding to the mounting portion 18 of the microphone element 3 in the package 500A. The bottom surface of the recessed portion 13 in the perforated lid 7B is the thin plate portion 11C thinner than other regions, and the plurality of through holes 12 are formed in the thin plate portion 11C.

The perforated lid 7B is a lid that seals the microphone element 3. The term "seals the microphone element 3" here does not mean to hermetically seal the housing recessed portion. The perforated lid 7B has the waterproof property for suppressing the water entry into the housing recessed portion, while having other performance (strength, or the like) required as the lid. In the present disclosure, as the same as and/or similar to the wiring board 10 and the like, the lid of such a package may also be referred to as a "substrate".

The through holes 12 and the recessed portion 13 provided in the perforated lid 7B are the same as and/or similar to those described in the first embodiment, and thus detailed description thereof is omitted. The thin plate portion 11C may be the same as or similar to the thin plate portion 11 described in the first embodiment, or may be a configuration different from the thin plate portion 11 (e.g., different materials, thicknesses, and the like) so as to correspond to the characteristics (strength, or the like) required for the lid of the package.

The perforated lid 7B in the present embodiment is a laminate body formed by layering a first layer 701 forming the thin plate portion 11C and a second layer 702 in which an opening portion serving as the recessed portion 13 is formed at a position corresponding to the thin plate portion 11C.

Each of the first layer 701 and the second layer 702 is an insulation layer composed of an insulation material including a ceramic material such as an aluminum oxide-based sintered body, a glass ceramic sintered body, a mullite-based sintered body, or an aluminum nitride-based sintered body. The perforated lid 7B can be manufactured using, for example, a method the is the same as or similar to the manufacturing method of the wiring board 10 described in the first embodiment.

The microphone device 210 includes the perforated lid 7B made of ceramic having a waterproof function, and has a structure in which the microphone element 3 is disposed below the recessed portion 13 and the fine through holes 12. An electronic apparatus (not illustrated in the present embodiment, see FIG. 18) including the microphone device 210 is configured by the microphone device 210 being bonded to, for example, the casing and the mounting substrate. In an example, the electronic apparatus is configured such that, for example, the perforated lid 7B and the casing are bonded to each other via a sealing material so that the recessed portion 13 of the perforated lid 7B and the sound hole formed in the casing communicate with each other. The electronic apparatus is configured by electrically connecting the terminal electrode 2D provided on the lower surface of the wiring board 10D to the electrode of the mounting substrate, in other words, by mounting the wiring board 10D on the mounting substrate. Note that the perforated lid 7B may include the sealing metal layer 8 on the upper surface of the perforated lid 7B so as to surround the recessed portion 13.

According to the package 500A and the microphone device 210 in the present embodiment, as the same as or similar to the first embodiment, the thickness (substrate thickness) of the perforated lid 7B can be ensured while improving the acoustic characteristics. The recessed portion 13 is formed in the perforated lid 7B, and thus a ratio of the space between the opening (for example, the sound hole formed in the casing) in contact with the outside and the microphone element 3 increases, and good acoustic characteristics can be obtained.

### Variation

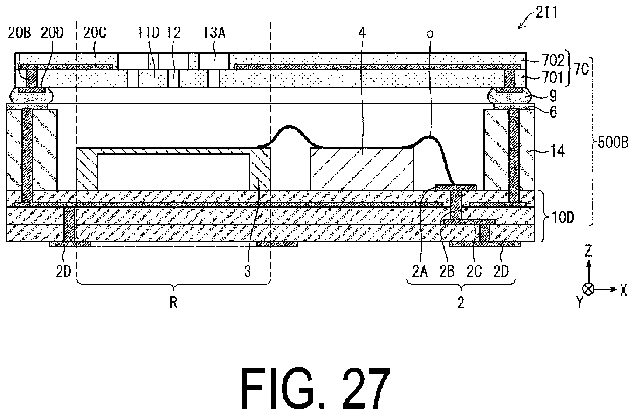

(2A) A variation of the second embodiment will be described below with reference to FIG. 27. FIG. 27 is a cross-sectional view of a microphone device 211 in the variation of the second embodiment.

As illustrated in FIG. 27, the microphone device 211 includes a package 500B, the microphone element 3, the semiconductor element 4, the wiring conductor 2, the connecting member 5, and the sealing metal layer 8. The package 500B includes the wiring board 10D, the frame-shaped portion 14, and a perforated lid 7C.

The perforated lid 7C differs from the above-described perforated lid 7B in that the perforated lid 7C includes the plurality of second recessed portions 13A in the region R corresponding to the mounting portion 18 of the microphone element 3 in the package 500B. The bottom surface of the second recessed portion 13A in the perforated lid 7C is the thin plate portion 11D thinner than other regions, and the plurality of through holes 12 are formed in the thin plate portion 11D.

The perforated lid 7C is a laminate body formed by layering a first layer 701 forming the thin plate portion 11D and a second layer 702 including the plurality of recessed portions 13 at a position corresponding to the thin plate portion 11C.

A wiring conductor that functions as a shield against noise from a side of the housing recessed portion may be provided. Specifically, as illustrated in FIG. 27, a plurality of the through hole conductors 2B may be provided at predetermined intervals in the frame-shaped portion 14, and the housing recessed portion may be configured to be surrounded by the plurality of through hole conductors 2B at the ground potential. According to the configuration, acoustic noise is reduced, and the reliability of operation is improved.

According to the package 500B and the microphone device 211 according to the present embodiment, the spatial volume of the second recessed portion 13A can be reduced, and thus strength as the substrate can be improved. As a result, the perforated lid 7C can be made further thinner.

(2B) In other variations of the second embodiment, the perforated lid 7B or the perforated lid 7C may have a structure in which the recessed portion 13 and the microphone element 3 face each other, in other words, a structure in which the recessed portion 13 is provided on the mounting portion 18 side.

The perforated lid 7B or the perforated lid 7C may be configured by three or four or more multi-layered insulation layers, and in this case, as the same as or similar to that described in the first embodiment, a structure may be configured such that the recessed portions are included on both sides of the lid.

### Third Embodiment

Another embodiment of the present disclosure will be described below with reference to accompanying drawings.

In the first embodiment, the microphone device 200 is described in which both the microphone element 3 and the semiconductor element 4 are mounted on the wiring board 10. In contrast, in the present embodiment, a package 600 will be described as another example of the package of the present disclosure, in which the package 600 includes a first wiring board on which the microphone element 3 is mounted, and a second wiring board on which the semiconductor element 4 is mounted. A microphone device 220 including the package 600 and the microphone element 3 will be also described.

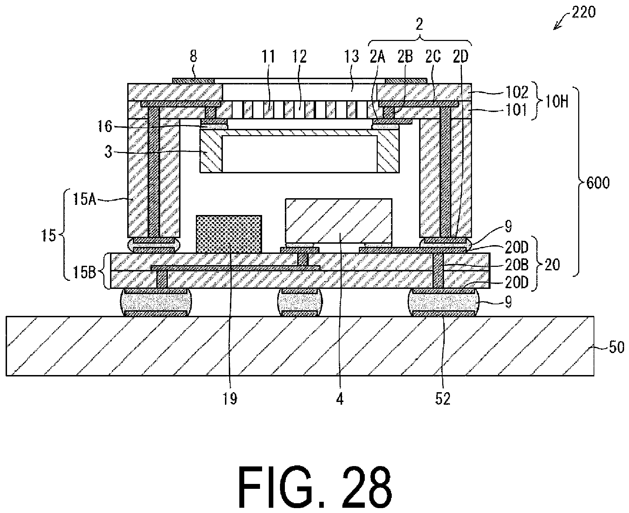

FIG. 28 is a cross-sectional view of the microphone device 220 according to the present embodiment. As illustrated in FIG. 28, the microphone device 220 includes the package 600, the microphone element 3, the semiconductor element 4, and a capacitor 19. The microphone device 220 is mounted on the mounting substrate 50.

The package 600 in the present embodiment includes a wiring board (first wiring board) 10H, and the relay substrate 15. The relay substrate 15 includes the frame-shaped portion 15A and the flat plate portion (second wiring board) 15B that blocks the opening of the frame-shaped portion 15A, and the inner portion of the frame-shaped portion 15A and the flat plate portion 15B includes the wiring conductor 20. The frame-shaped portion 15A may be bonded to the wiring board 10H. The frame-shaped portion 15A and the flat plate portion 15B are bonded to each other via the electrically conductive bonding material 9. The terminal electrode 20D on a surface of the flat plate portion 15B and the wiring 52 of the mounting substrate 50 are electrically bonded to each other via the electrically conductive bonding material 9.

The mounting portion 18 (see FIG. 2), which is not illustrated in the drawing, is provided on the wiring board 10H, and the microphone element 3 and the wiring board 10H are flip-chip connected to each other at the position of the mounting portion 18. In other words, the microphone element 3 is connected to the connection pad 2A via a terminal 16.

The wiring board 10H includes the recessed portion 13 in the region R corresponding to the mounting portion 18. The bottom surface of the recessed portion 13 in the wiring board 10H is the thin plate portion 11 thinner than other regions, and the plurality of through holes 12 are formed in the thin plate portion 11. The wiring conductor 2 is provided on the surface and in the inner portion of the wiring board 10H.

Elements other than the microphone element 3 such as the semiconductor element 4 and the capacitor 19 are mounted on the flat plate portion 15B in the relay substrate 15. The semiconductor element 4 and the capacitor 19 are electrically connected to the microphone element 3 and the mounting substrate 50 via various wiring members to form an electrical circuit. Examples of the various wiring members include the wiring conductor 2, the wiring conductor 20, and the electrically conductive bonding material 9.

In the package 600 according to the present embodiment, the microphone element 3 and the elements other than the microphone element 3 are mounted on a respective one of the wiring boards different from each other. As a result, the surface area occupied by the package 600 on the surface of the mounting substrate 50 can be reduced. Thus, the package 600 and the microphone device 220 can be miniaturized.

The elements other than the microphone element 3 such as the semiconductor element 4 and the capacitor 19 are preferably mounted on the flat plate portion 15B in the region R. As a result, the package 600 and the microphone device 220 can be further easily miniaturized.

Note that the wiring board 10H of the microphone device 220 may be mounted on the mounting substrate 50 so as to face the mounting substrate 50. In this case, the opening portion 51 (see FIG. 14) is provided in a portion corresponding to the recessed portion 13 of the mounting substrate 50. As another embodiment, the frame-shaped portion 15A may be integrated with the flat plate portion 15B, in other words, the relay substrate 15 (second wiring board) may include the housing recessed portion.

### Fourth Embodiment

Another embodiment of the present disclosure will be described below with reference to accompanying drawings.

In the third embodiment, the package 600 is described, in which the package 600 includes the first wiring board on which the microphone element 3 is mounted, and the second wiring board on which the semiconductor element 4 is mounted. In contrast, in the present embodiment, a package 700 and a microphone device 230 will be described, in which the package 700 includes a wiring base member 25 having a shape including cavities (housing recessed portions) on both sides and the perforated lid 7B, and in which the microphone device 230 includes the package 700 and the microphone element 3.

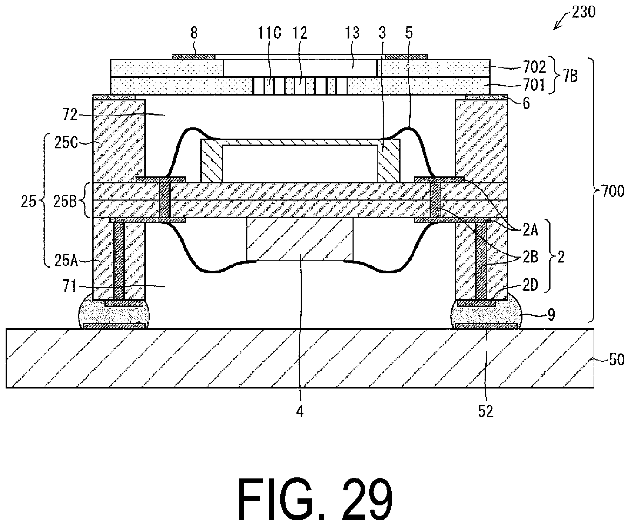

FIG. 29 is a cross-sectional view of the microphone device 230 according to the present embodiment. As illustrated in FIG. 29, the microphone device 230 includes the package 700, the microphone element 3, the semiconductor element 4, and the connecting member 5. The microphone device 230 is mounted on the mounting substrate 50.

The package 700 in the present embodiment includes the wiring base member 25, and the perforated lid 7B. The wiring base member 25 includes a flat plate portion 25B, a frame-shaped portion 25A bonded to a lower surface side of the flat plate portion 25B, and a frame-shaped portion 25C bonded to an upper surface side of the flat plate portion 25B. The wiring base member 25 includes the wiring conductor 2 in the inner portion of the frame-shaped portion 25A. The wiring base member 25 has a cross-section of an H shape, a first housing recessed portion 71 is formed on a lower surface side by the frame-shaped portion 25A, and a second housing recessed portion 72 is formed on an upper surface side by the frame-shaped portion 25C. By mounting the microphone device 230 on the mounting substrate 50, an opening of the first housing recessed portion 71 is sealed by the mounting substrate 50. An opening of the second housing recessed portion 72 is sealed by the perforated lid 7B.

The package 700 is provided with the mounting portion 18 (see FIG. 2) on an upper surface of the flat plate portion 25B in the wiring base member 25. In the microphone device 230, the microphone element 3 is mounted at a position of the mounting portion 18 on an upper surface of the wiring base member 25. In the microphone device 230 the semiconductor element 4 is mounted on a lower surface of the wiring base member 25 in the region R.

The wiring base member 25 may have a shape such that, for example, the housing recessed portion is rectangular or a shape such that the housing recessed portion is circular, when viewed in plan view from the mounting portion 18 side.

The perforated lid 7B includes the recessed portion 13A in the region R corresponding to the mounting portion 18 of the microphone element 3 in the package 700.

According to the package 700 in the present embodiment, the surface area occupied by the package 700 on the surface of the mounting substrate 50 can be reduced while using the perforated lid 7B including the recessed portion 13 and the thin plate portion 11C. The perforated lid 7B need not include the wiring conductor. Thus, the package 700 and the microphone device 230 can be miniaturized, and can be easily manufactured.

### Fifth Embodiment

Another embodiment of the present disclosure will be described below with reference to accompanying drawings.

In the fourth embodiment, the package 700 including the wiring base member 25 having a shape including the cavity on both sides and the perforated lid 7B is described. In contrast, in the present embodiment, a package 800 will be described, in which the package 800 includes the wiring board 10D including the cavity on the lower surface side, a sealing body 21 provided on the upper surface of the wiring board 10D, and the perforated lid 7B disposed below the wiring board 10D. A microphone device 240 including the package 800 and the microphone element 3 will be also described.

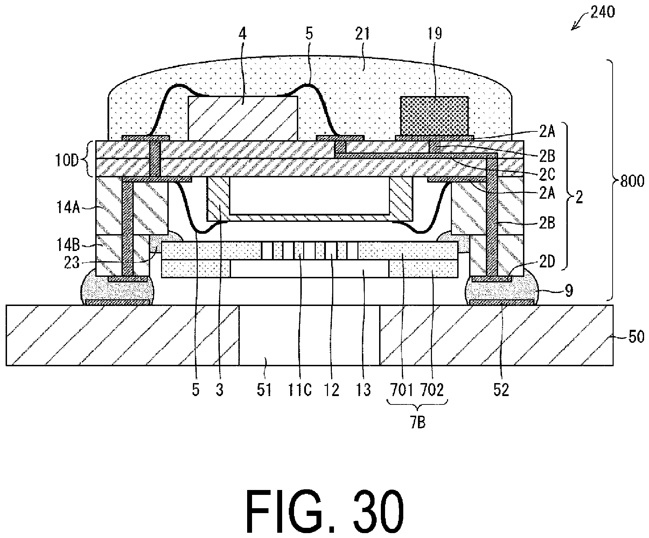

FIG. 30 is a cross-sectional view of the microphone device 240 according to the present embodiment. As illustrated in FIG. 30, the microphone device 240 includes the package 800, the microphone element 3, the semiconductor element 4, the capacitor 19, the connecting member 5, and the sealing body 21. The microphone device 240 is mounted on the mounting substrate 50.

The package 800 in the present embodiment includes the wiring board 10D, a frame-shaped portion 14A and a frame-shaped portion 14B provided on the bottom surface of the wiring board 10D, and the perforated lid 7B. The package 800 includes the housing recessed portion formed by the wiring board 10D and the frame-shaped portion 14A and the frame-shaped portion 14B on the lower surface side of the wiring board 10D.

The wiring board 10D and the frame-shaped portion 14A are bonded to each other, and the frame-shaped portion 14A and the frame-shaped portion 14B are bonded to each other. The package 800 includes the wiring conductor 2 in the inner portion of the wiring board 10D and in the inner portions of the frame-shaped portion 14A and the frame-shaped portion 14B. The terminal electrode 2D of the frame-shaped portion 14B and the wiring 52 of the mounting substrate 50 are bonded to each other via the electrically conductive bonding material 9.

The frame-shaped portion 14A and the frame-shaped portion 14B in the package 800 may have a shape such that, for example, the housing recessed portion is rectangular or a shape such that the housing recessed portion is circular, when the wiring board 10D is viewed in plan view from the lower surface side.

In the package 800 according to the present embodiment, a distance from one outer wall surface of the frame-shaped portion 14A to the other outer wall surface facing the one outer wall surface has a size that is the same as or similar to a distance from one outer wall surface of the frame-shaped portion 14B to the other outer wall surface facing the one outer wall surface. Further, a distance from one inner wall surface of the frame-shaped portion 14A to the other inner wall surface facing the one inner wall surface has a smaller size than a distance from one inner wall surface of the frame-shaped portion 14B to the other inner wall surface facing the one inner wall surface. In other words, the package 800 includes a shelf portion (step portion) at a boundary portion between the frame-shaped portion 14A and the frame-shaped portion 14B in the housing recessed portion.

In the microphone device 240, the semiconductor element 4 and, if necessary, the capacitor 19 are mounted on the upper surface of the wiring board 10D, and the semiconductor element 4 and the wiring conductors 2 are electrically connected to each other by the connecting member 5. The microphone device 240 includes the sealing body 21 on the upper surface of the wiring board 10D so as to seal the semiconductor element 4, the connecting member 5, and the capacitor 19. The sealing body 21 may be, for example, a resin power compact or other materials. For example, the sealing body 21 can be formed by coating (potting) with resin or the like.

The microphone device 240 may include the frame-shaped portion 14 on the upper surface of the wiring board 10D, and the housing recessed portion may be formed. According to this configuration, sealing can be performed by filling the housing recessed portion with a sealing resin, and thus the possibility of the sealing resin flowing out to the side can be reduced. The strength of the wiring board is improved.

In the microphone device 240, the microphone element 3 is mounted on the mounting portion 18 on the lower surface of the wiring board 10D. The microphone element 3 and the wiring conductor 2 are electrically connected to each other by the connecting member 5.

In the microphone device 240, the perforated lid 7B is fixed to the shelf portion via the bonding material 23 in the housing recessed portion. The perforated lid 7B is disposed such that the recessed portion 13 faces the opening portion 51 of the mounting substrate 50. As a result, the opening of the housing recessed portion is covered with the perforated lid 7B, and the microphone element 3 is sealed.

The semiconductor element 4 and the capacitor 19 are preferably mounted on the wiring board 10D so that at least a part of the semiconductor element 4 and the capacitor 19 are present in the region R.

According to the package 800 in the present embodiment, the surface area occupied by the package 800 on the surface of the mounting substrate 50 can be reduced. Thus, the package 800 and the microphone device 240 can be miniaturized.

In the present disclosure, the invention has been described above based on the various drawings and examples. However, the invention according to the present disclosure is not limited to each embodiment described above. In other words, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, note that a person skilled in the art can easily make various variations or modifications based on the present disclosure. Note that these variations or modifications are included within the scope of the present disclosure.

### REFERENCE SIGNS

3 Microphone element
4 Semiconductor element
5 Connecting member
7, 7A Lid
7 B, 7C, 7D Perforated lid (Substrate)
10, 10A, 10B, 10C, 10E, 10F Wiring board (Substrate)
10D Wiring board
11, 11A, 11B, 11C, 11D, 11E, 11F Thin plate portion
12, 12A, 12B, 12C, 12D, 12E, 12F, 12G, 12H Through hole
13 Recessed portion
13A Second recessed portion
17 Coating layer
18 Mounting portion
50 Mounting substrate
200, 201, 202, 203, 204, 205, 206, 207, 208, 210, 211, 220, 230, 240 Microphone device
300, 301 Electronic apparatus
400, 500A, 500B, 600, 700, 800 Package
R Region

## Claims

1. A package on which a microphone element is to be mounted, the package comprising;
a substrate comprising at least one recessed portion in a region corresponding to a mounting portion of a microphone element in a package, wherein
a bottom surface of the recessed portion in the substrate is a thin plate portion that is thinner than a thickness of another region, and
the substrate comprises a plurality of through holes in the thin plate portion.

2. The package according to claim 1, wherein
an opening of the recessed portion is located on a surface opposite to the mounting portion in the substrate.

3. The package according to claim 1, wherein
an opening of the recessed portion is located on a surface on a mounting portion side in the substrate.

4. The package according to claim 1, wherein
an opening of the recessed portion is located on each of both surfaces of the substrate with the thin plate portion interposed between the both surfaces.

5. The package according to any one of claims 1 to 4, wherein
the substrate comprises the plurality of through holes in the thin plate portion of the bottom surface of one recessed portion.

6. The package according to any one of claims 1 to 5, wherein
the recessed portion has a two-stage shape comprising a plurality of second recessed portions on a bottom surface, and
a bottom surface of each of the plurality of second recessed portions is the thin plate portion.

7. The package according to any one of claims 1 to 6, wherein
the plurality of through holes do not allow water to permeate when the substrate is submerged in water at a depth of 1 m for 30 minutes.

8. The package according to any one of claims 1 to 7, wherein
the plurality of through holes are located in a position separated from an outer edge of the recessed portion when the bottom surface of the recessed portion is viewed in plan view.

9. The package according to any one of claims 1 to 8, wherein
the plurality of through holes have a staggered arrangement when the bottom surface of the recessed portion is viewed in plan view.

10. The package according to any one of claims 1 to 9, wherein
the substrate comprises a coating layer comprising a water-repellent function on a surface opposite to the mounting portion.

11. The package according to any one of claims 1 to 10 wherein
the substrate is a wiring board comprising the mounting portion and a wiring.

12. The package according to any one of claims 1 to 10, wherein
the substrate is a lid configured to seal the microphone element.

13. The package according to any one of claims 1 to 12, wherein
the substrate is a laminate body comprising a plurality of insulation layers, and
the substrate comprises
a first insulation layer comprising the thin plate portion, and
a second insulation layer in contact with the first insulation layer and comprising an opening portion at a position corresponding to the thin plate portion.

14. The package according to claim 13, wherein
the insulation layer is a ceramic insulation layer.

15. A microphone device comprising:
the package according to any one of claims 1 to 14; and
a microphone element.

16. An electronic apparatus comprising:
the microphone device according to claim 15.
